# EUROPEAN PATENT APPLICATION

(11) **EP 4 782 862 A2**
(43) Date of publication of application: **29.07.2026**
(21) Application number: 26154751.7
(22) Date of filing: 28.01.2026
(51) Int. Cl.: G01R 33/48, G01R 33/56, G01R 33/565, G01R 33/561

(54) **MAGNETIC RESONANCE IMAGING APPARATUS AND OPERATION METHOD OF MAGNETIC RESONANCE IMAGING APPARATUS**

(30) Priority: 28.01.2025 JP 2025012494
(71) Applicant: FUJIFILM Corporation, Tokyo 106-8620 (JP)
(72) Inventor: SUZUKI, Atsuro, Tokyo, 106-8620 (JP); SHIRAI, Toru, Tokyo, 106-8620 (JP); YOKOSAWA, Suguru, Tokyo, 106-8620 (JP); SHOJI, Hiroki, Tokyo, 106-8620 (JP); HIRAKAWA, Yuya, Tokyo, 106-8620 (JP)
(74) Representative: Dehns Germany Partnerschaft mbB

(57) **Abstract**

A magnetic resonance imaging apparatus (10) includes a processor (202) which is configured to: acquire second partial measurement data of a second measurement region excluding a second unmeasured region that is asymmetrical and arbitrarily set for a second k-space; fill the second unmeasured region with zero data and generate data of the second k-space consisting of the second partial measurement data and the zero data filling the second unmeasured region; and when second proportion of the second unmeasured region to an entire region of the second k-space is different from a first proportion of a first unmeasured region to an entire region of a first k-space corresponding to a training image used for training a trained model, generate data of a third k-space by filling an outer region of the second k-space with zero data such that the second proportion becomes the first proportion.

## Description

### BACKGROUND OF THE INVENTION

### 1. Field of the Invention

The present invention relates to a magnetic resonance imaging apparatus and an operation method of a magnetic resonance imaging apparatus, and particularly to a technique of collecting data of a k-space having an asymmetrical unmeasured region and improving image quality of a reconstruction image reconstructed from the collected data of the k-space.

### 2. Description of the Related Art

In a magnetic resonance imaging (MRI) apparatus, in order to reduce an imaging time, an imaging sequence for measuring data (partial measurement data) of a partially asymmetrical region in a k-space without measuring full measurement data in the k-space can be set.

In the related art, data of an asymmetrical unmeasured region other than a partial measurement region in the k-space is estimated from the measured partial measurement data by using "Hermitian conjugate" of the data of the k-space. Further, a half-Fourier method is used, in which data of a k-space consisting of the measured partial measurement data and estimated data for the unmeasured region is subjected to an inverse Fourier transform to reconstruct the image. However, in a case in which the unmeasured region increases, the degradation of image quality becomes greater.

Meanwhile, US2022/0198725A discloses a technique of improving the degradation of image quality caused by zero data in an unmeasured region by filling an asymmetrical unmeasured region with zero data, performing an inverse Fourier transform on data of a k-space consisting of measured partial measurement data and data of the unmeasured region filled with the zero data to generate a reconstruction image, and inputting the generated reconstruction image to a trained model (convolutional neural network (CNN)).

### SUMMARY OF THE INVENTION

In a method of reducing the degradation of image quality using the CNN described in US2022/0198725A, it is necessary to prepare a CNN trained for each proportion of the unmeasured region in the k-space.

The half-Fourier method installed in the MRI apparatus supports an unmeasured percentage from 1% to 45% in 1% increments. In addition, since there are four directions (positive and negative kₓ directions and positive and negative k_{y} directions) in the k-space as the directions of the unmeasured region, it is necessary to prepare a CNN corresponding to each direction.

In a case in which a CNN with an unmeasured percentage in 1% increments is prepared, it is necessary to prepare 45 CNNs corresponding to 45 patterns in a case in which the direction of the unmeasured region is only a positive kₓ direction of the k-space, it is necessary to prepare 2,025 CNNs corresponding to 45 × 45 patterns in a case in which the direction of the unmeasured region is a combination of the positive kₓ direction and the positive k_{y} direction, and it is necessary to prepare 91,125 CNNs corresponding to 45 × 45 × 45 patterns in a case in which the k_{z} direction is also included as the direction of the unmeasured region, and the number of CNNs to be prepared is enormous.

Since the training time for the CNN corresponding to one pattern is 42 hours in a case of a 9-layer CNN and 40,000 training images, the training time for 91,125 CNNs corresponding to 45 × 45 × 45 patterns is calculated as 45 × 45 × 45 × 42 = 437 (years), which is not practical, and the cost of managing a large number of CNNs is also high.

The present invention has been made in view of such circumstances, and an object thereof is to provide a magnetic resonance imaging apparatus and an operation method of a magnetic resonance imaging apparatus that can apply a common trained model even in a case in which a proportion of an asymmetrical unmeasured region to an entire region of a k-space is arbitrarily set, thereby reducing the number of trained models and reducing a training time.

A first aspect of the present invention relates to a magnetic resonance imaging apparatus comprising: a processor; and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the processor is configured to: acquire second partial measurement data of a second measurement region excluding a second unmeasured region that is asymmetrical and arbitrarily set for a second k-space; fill the second unmeasured region with zero data and generate data of the second k-space consisting of the second partial measurement data and the zero data filling the second unmeasured region; and in a case in which a first proportion of the first unmeasured region with respect to an entire region of the first k-space and a second proportion of the second unmeasured region with respect to an entire region of the second k-space are different from each other, generate data of a third k-space by filling an outer region of the second k-space with zero data such that the second proportion becomes the first proportion.

The trained model is a model that reduces the degradation of image quality, which is caused by the zero data filling the first unmeasured region, in the reconstruction image reconstructed from the data consisting of the first partial measurement data of the first measurement region excluding the first unmeasured region in the full measurement data of the first k-space and the zero data filling the first unmeasured region having the first proportion with respect to the entire region of the first k-space, from the reconstruction image input to the trained model, and the proportion of the unmeasured region of the data of the k-space corresponding to a Fourier transform on the reconstruction image needs to match the first proportion of the first unmeasured region of the first k-space corresponding to a Fourier transform on the training image during training of the trained model.

According to the first aspect of the present invention, by arbitrarily setting the asymmetrical second unmeasured region for the second k-space and generating the data of the second k-space consisting of the second partial measurement data of the second measurement region excluding the asymmetrical second unmeasured region and the zero data filling the second unmeasured region, it is possible to reduce the imaging time as compared to a case where the measurement data of the entire region of the second k-space is acquired. In addition, in a case in which the proportion (second proportion) of the second unmeasured region with respect to the entire region of the second k-space is different from the first proportion of the first unmeasured region of the first k-space corresponding to a Fourier transform on the training image, the outer region of the second k-space is filled with zero data such that the second proportion becomes the first proportion to generate the data of the third k-space, and the trained model is used for the reconstruction image reconstructed by performing an inverse Fourier transform on the data of the third k-space, thereby improving the degradation of image quality of the reconstruction image. That is, even in a case in which the proportion of the asymmetrical second unmeasured region is arbitrarily set, the common trained model can be used, thereby reducing the number of trained models.

A first embodiment of the present invention relates to the magnetic resonance imaging apparatus according to the first aspect, the trained model is configured by a neural network.

A second embodiment of the present invention relates to the magnetic resonance imaging apparatus according to the first aspect or the first embodiment, in which it is preferable that the second proportion is less than the first proportion. This is because the second partial measurement data of the second k-space can be effectively used.

A third embodiment of the present invention relates to the magnetic resonance imaging apparatus according to the first aspect or first embodiment or second embodiment, it is preferable that the processor is configured to: perform an inverse Fourier transform on the data of the third k-space to generate a third reconstruction image; input the third reconstruction image as an input image to the trained model and acquire an output image from the trained model as an intermediate image; perform a Fourier transform on the intermediate image to generate data of a fourth k-space; delete a region corresponding to zero data filling an outer region of the third k-space from the data of the fourth k-space to generate data of a fifth k-space; and perform an inverse Fourier transform on the data of the fifth k-space to generate an output image. As a result, it is possible to generate a final image having a desired image size in which the degradation of the reconstruction image caused by the zero data filling the second unmeasured region of the second k-space is reduced.

A fourth embodiment of the present invention relates to the magnetic resonance imaging apparatus according to the first aspect or any one of the first to third embodiments, it is preferable that the processor is configured to: in a case in which the first proportion and the second proportion match each other, perform an inverse Fourier transform on the data of the second k-space to generate the second reconstruction image; and input the second reconstruction image as an input image to the trained model and acquire an output image from the trained model. That is, in a case in which the second proportion of the second unmeasured region with respect to the entire region of the second k-space matches the first proportion of the first unmeasured region of the first k-space corresponding to a Fourier transform on the training image, the second reconstruction image is generated by performing an inverse Fourier transform on the data of the second k-space without filling the outer region of the second k-space with the zero data, and the second reconstruction image is input as the input image of the trained model to the trained model, thereby acquiring the output image having improved image quality from the trained model.

A fifth embodiment of the present invention relates to the magnetic resonance imaging apparatus according to the first aspect or any one of first to fourth embodiment, it is preferable that the memory stores, as the trained model, a plurality of trained models having different first proportions, and the processor is configured to: in a case in which the first proportion and the second proportion are different from each other, select a trained model for which the first proportion closest to the second proportion is set from among the plurality of trained models; and generate the data of the third k-space by filling the outer region of the second k-space with the zero data such that the second proportion becomes the first proportion set for the selected trained model. As a result, it is possible to improve the image quality of the output image by using a trained model that is more suitable while minimizing the zero data filling the outer region of the second k-space.

A sixth embodiment of the present invention relates to the magnetic resonance imaging apparatus according to the first aspect or any of the first to fifth embodiments, it is preferable that the memory stores a plurality of trained models corresponding to four directions of the first k-space and directions formed by combining the four directions, in relation to a direction of the first unmeasured region of the first k-space, and the processor is configured to select a trained model corresponding to the same direction as a direction of the second unmeasured region of the second k-space from among the plurality of trained models. Since the trained model is used to reduce the degradation of image quality caused by the zero data filling the unmeasured region, it is necessary to select an appropriate trained model for the direction of the second unmeasured region of the second k-space, and by selecting the appropriate trained model, it is possible to match the direction of the first unmeasured region of the first k-space corresponding to the selected trained model with the direction of the second unmeasured region of the second k-space.

An seventh embodiment of the present invention relates to a magnetic resonance imaging apparatus comprising: a processor; and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the processor is configured to: acquire second partial measurement data of a second measurement region excluding a second unmeasured region that is asymmetrical and arbitrarily set for a second k-space; fill the second unmeasured region with zero data and generate data of the second k-space consisting of the second partial measurement data and the zero data filling the second unmeasured region; in a case in which a first proportion of the first unmeasured region with respect to an entire region of the first k-space and a second proportion of the second unmeasured region with respect to an entire region of the second k-space are different from each other, generate data of a third k-space in which data of an outer region of the second k-space is deleted such that the second proportion becomes the first proportion; perform an inverse Fourier transform on the data of the third k-space to generate a third reconstruction image; input the third reconstruction image as an input image to the trained model and acquire an output image from the trained model as a first intermediate image; and generate data of a fourth k-space by adding the deleted data to an outer region of data obtained by performing a Fourier transform on the first intermediate image.

According to the seventh embodiment of the present invention, in a case in which the first proportion of the first unmeasured region with respect to the entire region of the first k-space and the second proportion of the second unmeasured region with respect to the entire region of the second k-space are different from each other, the data of the third k-space is generated by deleting the data in the outer region of the second k-space such that the second proportion becomes the first proportion, and thus it is possible to match the proportion of the unmeasured region in the third k-space with the first proportion of the first unmeasured region in the first k-space. It is possible to perform image processing for improving image quality by the trained model on the third reconstruction image generated by performing an inverse Fourier transform on the data of the third k-space. That is, even in a case in which the first proportion of the first unmeasured region with respect to the entire region of the first k-space and the second proportion of the second unmeasured region with respect to the entire region of the second k-space are different from each other, the common trained model can be applied. The data of the fourth k-space generated by adding the deleted data to the outer region of the data obtained by performing a Fourier transform on the image (first intermediate image) obtained by inputting the third reconstruction image to the trained model is data in which the zero data of the unmeasured region of the third k-space is corrected by the trained model.

A eighth embodiment of the present invention relates to the magnetic resonance imaging apparatus according to the seventh embodiment, it is preferable that the processor is configured to generate data of a fifth k-space by filling an outer region of the fourth k-space with zero data such that a fourth proportion of an outer unmeasured region with respect to an entire region of the fourth k-space becomes the first proportion. As a result, the same data of the fifth k-space as the data of the third k-space generated by the magnetic resonance imaging apparatus according to the first aspect of the present invention can be generated.

A ninth embodiment of the present invention relates to the magnetic resonance imaging apparatus according to the eighth embodiment, it is preferable that the processor is configured to: perform an inverse Fourier transform on the data of the fifth k-space to generate a fifth reconstruction image; input the fifth reconstruction image as an input image to the trained model and acquire an output image from the trained model as a second intermediate image; perform a Fourier transform on the second intermediate image to generate data of a sixth k-space; delete a region corresponding to zero data filling an outer region of the fifth k-space from the data of the sixth k-space to generate data of a seventh k-space; and perform an inverse Fourier transform on the data of the seventh k-space to generate an output image. As a result, it is possible to generate the final image having a desired image size in which the degradation of image quality is reduced, as in the magnetic resonance imaging apparatus according to the third embodiment of the present invention.

An tenth embodiment of the present invention relates to the magnetic resonance imaging apparatus according to the first aspect or first to sixth embodiment, it is preferable that the first unmeasured region that is asymmetrical and set in advance for the first k-space is a region of an end part of the first k-space in any specific direction among four directions, and the processor is configured to: in a case in which a direction of the second unmeasured region of the second k-space is different from the specific direction, rotate or invert the data of the third k-space such that a direction of an unmeasured region of the data of the third k-space matches the specific direction, and generate a third reconstruction image by performing an inverse Fourier transform on the rotated or inverted data of the third k-space or by rotating or inverting an image generated by performing an inverse Fourier transform on the data of the third k-space; and input the third reconstruction image as an input image to the trained model and acquire an output image from the trained model.

In a case in which the direction (specific direction) of the first unmeasured region of the first k-space corresponding to a Fourier transform on the training image of the trained model is different from the direction of the second unmeasured region of the second k-space, the third reconstruction image is generated by rotating or inverting the data of the third k-space such that the direction of the unmeasured region of the data of the third k-space generated by filling the outer region of the second k-space with the zero data matches the specific direction, and performing an inverse Fourier transform on the rotated or inverted data of the third k-space or by rotating or inverting the image generated by performing an inverse Fourier transform on the data of the third k-space, and thus the trained model can be applied to the generated third reconstruction image, thereby reducing the number of trained models.

A eleventh embodiment of the present invention relates to the magnetic resonance imaging apparatus according to the tenth aspect, it is preferable that the processor is configured to rotate or invert the output image in a direction opposite to a direction of the rotation in a case of generating the third reconstruction image.

A twelfth embodiment of the present invention relates to a magnetic resonance imaging apparatus comprising: a processor; and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the processor is configured to: acquire second partial measurement data of a second measurement region excluding a second unmeasured region that is asymmetrical and set for a second k-space, the second unmeasured region being a first region and a second region that are two regions adjacent to each other among regions at end parts of the second k-space in four directions; fill the second unmeasured region with zero data and generate data of the second k-space consisting of the second partial measurement data and the zero data filling the second unmeasured region; perform an inverse Fourier transform on the data of the second k-space to generate a first intermediate image; input the first intermediate image as an input image to the trained model and acquire an output image from the trained model as a second intermediate image; perform a Fourier transform on the second intermediate image to generate data of a third k-space, and generate data of a fourth k-space by rotating the data of the third k-space such that a direction of an unmeasured region of the third k-space matches a direction of the first unmeasured region or by rotating the second intermediate image and performing a Fourier transform on the rotated second intermediate image; perform an inverse Fourier transform on the data of the fourth k-space to generate a fourth reconstruction image; and input the fourth reconstruction image as an input image to the trained model and acquire an output image from the trained model.

According to the twelfth embodiment of the present invention, even in a case in which the direction of the asymmetrical second unmeasured region set for the second k-space spans the directions of the first region and the second region that are two regions adjacent to each other among the regions at the end parts of the second k-space in the four directions, it is possible to reduce the degradation of image quality by applying the common trained model, and it is possible to reduce the number of trained models.

A thirteenth embodiment of the present invention relates to the magnetic resonance imaging apparatus according to the twelfth embodiment, it is preferable that the processor is configured to rotate the output image in a direction opposite to a direction of the rotation in a case of generating the fourth reconstruction image.

A fourteenth embodiment of the present invention relates to a magnetic resonance imaging apparatus comprising: a processor; and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the processor is configured to: acquire second partial measurement data of a second measurement region excluding a second unmeasured region that is asymmetrical and arbitrarily set for a second k-space; fill the second unmeasured region with zero data and generate data of the second k-space consisting of the second partial measurement data and the zero data filling the second unmeasured region; in a case in which a first proportion of the first unmeasured region with respect to an entire region of the first k-space and a second proportion of the second unmeasured region with respect to an entire region of the second k-space are different from each other, generate data of a third k-space by replacing a partial region of the second partial measurement data with zero data such that the second proportion becomes the first proportion; perform an inverse Fourier transform on the data of the third k-space to generate a third reconstruction image; input the third reconstruction image as an input image to the trained model and acquire an output image from the trained model as an intermediate image; perform a Fourier transform on the intermediate image to generate data of a fourth k-space; and combine the second partial measurement data of the second k-space with data corresponding to the second unmeasured region in the data of the fourth k-space to generate data of a fifth k-space.

According to the fourteenth embodiment of the present invention, in a case in which the first proportion of the first unmeasured region with respect to the entire region of the first k-space and the second proportion of the second unmeasured region with respect to the entire region of the second k-space are different from each other, the data of the third k-space is generated by replacing a partial region of the second partial measurement data with the zero data such that the second proportion becomes the first proportion. As a result, the trained model can be applied to the third reconstruction image generated by performing an inverse Fourier transform on the data of the third k-space. By using the third reconstruction image as the input image of the trained model, the output image (intermediate image) in which the degradation of image quality is reduced can be acquired from the trained model. Then, the data of the fifth k-space is generated by combining the second partial measurement data of the second k-space with the data corresponding to the second unmeasured region in the data of the fourth k-space obtained by performing a Fourier transform on the intermediate image. The data of the fifth k-space generated in this way is data in which the zero data filling the second unmeasured region of the second k-space is replaced with corrected data in which an estimation result by the trained model is reflected.

A fifteenth embodiment of the present invention relates to the magnetic resonance imaging apparatus according to the fourteenth embodiment, it is preferable that the processor is configured to perform an inverse Fourier transform on the data of the fifth k-space to generate a fifth reconstruction image. The fifth reconstruction image is an image in which the degradation of image quality caused by the zero data filling the second unmeasured region of the second k-space is improved.

A second aspect of the present invention relates to an operation method of a magnetic resonance imaging apparatus including a processor, and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the operation method is executed by the processor, the operation method comprising: a step of acquiring second partial measurement data of a second measurement region excluding a second unmeasured region that is asymmetrical and arbitrarily set for a second k-space; a step of filling the second unmeasured region with zero data and generating data of the second k-space consisting of the second partial measurement data and the zero data filling the second unmeasured region; and a step of, in a case in which a first proportion of the first unmeasured region with respect to an entire region of the first k-space and a second proportion of the second unmeasured region with respect to an entire region of the second k-space are different from each other, generating data of a third k-space by filling an outer region of the second k-space with zero data such that the second proportion becomes the first proportion.

An fifteenth embodiment of the present invention relates to an operation method of a magnetic resonance imaging apparatus including a processor, and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the operation method is executed by the processor, the operation method comprising: a step of acquiring second partial measurement data of a second measurement region excluding a second unmeasured region that is asymmetrical and arbitrarily set for a second k-space; a step of filling the second unmeasured region with zero data and generating data of the second k-space consisting of the second partial measurement data and the zero data filling the second unmeasured region; a step of, in a case in which a first proportion of the first unmeasured region with respect to an entire region of the first k-space and a second proportion of the second unmeasured region with respect to an entire region of the second k-space are different from each other, generating data of a third k-space in which data of an outer region of the second k-space is deleted such that the second proportion becomes the first proportion; a step of performing an inverse Fourier transform on the data of the third k-space to generate a third reconstruction image; a step of inputting the third reconstruction image as an input image to the trained model and acquiring an output image from the trained model as a first intermediate image; and a step of generating data of a fourth k-space by adding the deleted data to an outer region of data obtained by performing a Fourier transform on the first intermediate image.

A third aspect of the present invention relates to an operation method of a magnetic resonance imaging apparatus including a processor, and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the operation method is executed by the processor, the operation method comprising: a step of acquiring second partial measurement data of a second measurement region excluding a second unmeasured region that is asymmetrical and set for a second k-space, the second unmeasured region being a first region and a second region that are two regions adjacent to each other among regions at end parts of the second k-space in four directions; a step of filling the second unmeasured region with zero data and generating data of the second k-space consisting of the second partial measurement data and the zero data filling the second unmeasured region; a step of performing an inverse Fourier transform on the data of the second k-space to generate a first intermediate image; a step of inputting the first intermediate image as an input image to the trained model and acquiring an output image from the trained model as a second intermediate image; a step of performing a Fourier transform on the second intermediate image to generate data of a third k-space in which zero data of the first region of the data of the second k-space is corrected, and generating data of a fourth k-space by rotating the data of the third k-space such that a direction of an unmeasured region of the third k-space matches a direction of the first unmeasured region or by rotating the second intermediate image and performing a Fourier transform on the rotated second intermediate image; a step of performing an inverse Fourier transform on the data of the fourth k-space to generate a fourth reconstruction image; and a step of inputting the fourth reconstruction image as an input image to the trained model and acquiring an output image from the trained model.

A fourth aspect of the present invention relates to an operation method of a magnetic resonance imaging apparatus including a processor, and a memory that stores a trained model, in which the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and the operation method is executed by the processor, the operation method comprising: a step of acquiring second partial measurement data of a second measurement region excluding a second unmeasured region that is asymmetrical and arbitrarily set for a second k-space; a step of filling the second unmeasured region with zero data and generating data of the second k-space consisting of the second partial measurement data and the zero data filling the second unmeasured region; a step of, in a case in which a first proportion of the first unmeasured region with respect to an entire region of the first k-space and a second proportion of the second unmeasured region with respect to an entire region of the second k-space are different from each other, generating data of a third k-space by replacing a partial region of the second partial measurement data with zero data such that the second proportion becomes the first proportion; a step of performing an inverse Fourier transform on the data of the third k-space to generate a third reconstruction image; a step of inputting the third reconstruction image as an input image to the trained model and acquiring an output image from the trained model as an intermediate image; a step of performing a Fourier transform on the intermediate image to generate data of a fourth k-space; and a step of combining the second partial measurement data of the second k-space with data corresponding to the second unmeasured region in the data of the fourth k-space to generate data of a fifth k-space.

According to the aspects of the present invention, even in a case of using the data of the k-space that includes the asymmetrical unmeasured region for reducing the imaging time by the magnetic resonance imaging apparatus and in which the proportion of the asymmetrical unmeasured region with respect to the entire region of the k-space is arbitrarily set, a common trained model can be applied as the trained model that reduces the degradation of image quality of an MR image caused by the zero data of the unmeasured region, and thus it is possible to reduce the number of trained models and reduce the training time.

### BRIEF DESCRIPTION OF THE DRAWINGS

FIG. 1 is a diagram illustrating a schematic configuration of a magnetic resonance imaging apparatus according to an embodiment of the present invention.
FIG. 2 is a diagram illustrating examples of full measurement data of a k-space and an MR image reconstructed from the full measurement data.
FIG. 3 is a diagram illustrating examples of each point (kx, ky) of data disposed in the k-space and a k-trajectory.
FIG. 4 is a diagram illustrating four patterns of the k-space having data of an asymmetrical region to which a half-Fourier method can be applied.
FIG. 5 is a conceptual diagram illustrating a method of improving the degradation of image quality of the MR image using a CNN.
FIG. 6 is a diagram illustrating an example of the CNN applied as a trained model according to the embodiment of the present invention.
FIGS. 7A and 7B are diagrams illustrating examples of an input image and an output image of the CNN illustrated in FIG. 6.
FIG. 8 is a diagram illustrating a method of creating a training image set for training the CNN corresponding to four patterns in which directions of asymmetrical unmeasured regions of the k-space are different from each other.
FIG. 9 is a functional block diagram illustrating functions of a processor of a control device illustrated in FIG. 1.
FIG. 10 is a diagram illustrating a first embodiment of the MRI apparatus according to the embodiment of the present invention, and is a diagram particularly illustrating some functions of a k-space data generation unit of the processor illustrated in FIG. 9.
FIG. 11 is a diagram illustrating a second embodiment of the MRI apparatus according to the embodiment of the present invention, and is a diagram particularly illustrating some functions of an image calculation unit of the processor illustrated in FIG. 9.
FIG. 12 is a diagram illustrating a third embodiment of the MRI apparatus according to the embodiment of the present invention, and is a diagram particularly illustrating some functions of the image calculation unit of the processor illustrated in FIG. 9.
FIG. 13 is a diagram illustrating a fourth embodiment of the MRI apparatus according to the embodiment of the present invention, and is a diagram illustrating an embodiment in which a common CNN can be applied to data of a plurality of k-spaces in which the directions of the unmeasured regions of the k-space are different from each other.
FIG. 14 is a diagram illustrating a fifth embodiment of the MRI apparatus according to the embodiment of the present invention, and is a diagram illustrating an embodiment in which a common CNN can be applied to the data of the k-space in which the asymmetrical unmeasured regions in the k-space are present in two directions.
FIG. 15 is a diagram illustrating a sixth embodiment of the MRI apparatus according to the embodiment of the present invention, and is a diagram illustrating an embodiment in which a common CNN can be applied to the data of the k-space in which the asymmetrical unmeasured regions in the k-space are present in three directions in a three-dimensional space.
FIG. 16 is a diagram illustrating a seventh embodiment of the MRI apparatus according to the embodiment of the present invention, and is a diagram illustrating an embodiment in which a CNN can be applied to data of a second k-space in which a second proportion of an asymmetrical second unmeasured region with respect to an entire region of the second k-space is less than a first proportion of a first unmeasured region with respect to an entire region of a first k-space corresponding to a training image used for training the CNN.
FIG. 17 is a flowchart illustrating a first embodiment of an operation method of the MRI apparatus according to the embodiment of the present invention.
FIG. 18 is a subroutine illustrating processing of step S150 illustrated in FIG. 17.
FIG. 19 is a flowchart illustrating a part of processing in a case in which it is determined that the first proportion is less than the second proportion (in a case of "No") in step S130 illustrated in FIG. 17.
FIG. 20 is a flowchart illustrating a second embodiment of the operation method of the MRI apparatus according to the embodiment of the present invention.
FIG. 21 is a flowchart illustrating a third embodiment of the operation method of the MRI apparatus according to the embodiment of the present invention.

### DESCRIPTION OF THE PREFERRED EMBODIMENTS

Hereinafter, preferred embodiments of a magnetic resonance imaging apparatus and an operation method of a magnetic resonance imaging apparatus according to an embodiment of the present invention will be described with reference to the accompanying drawings.

### Configuration of Magnetic Resonance Imaging Apparatus

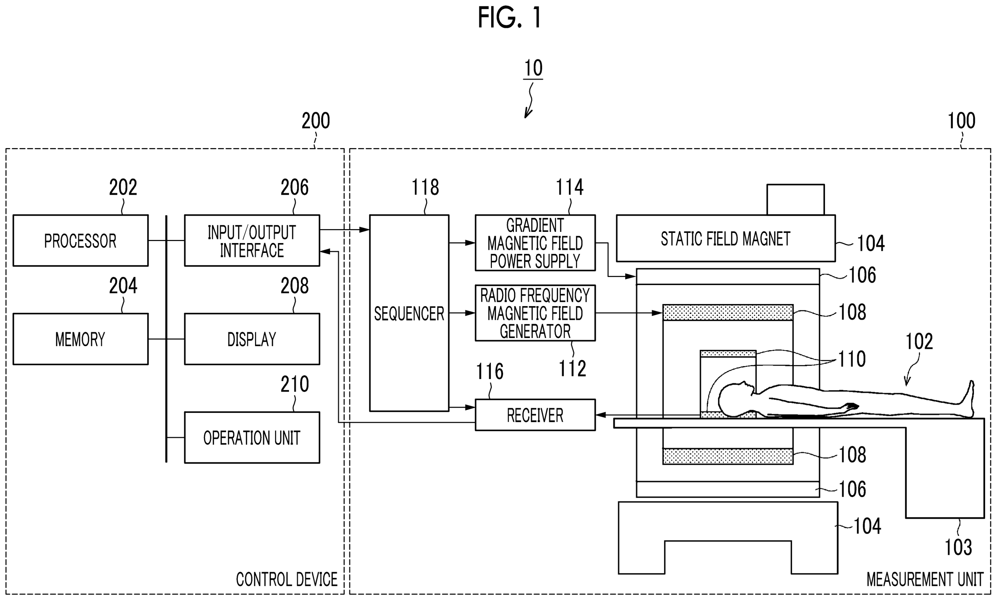

FIG. 1 is a diagram illustrating a schematic configuration of the magnetic resonance imaging apparatus according to the embodiment of the present invention.

As illustrated in FIG. 1, a magnetic resonance imaging apparatus (MRI apparatus) 10 includes a measurement unit 100 and a control device 200.

The measurement unit 100 illustrated in FIG. 1 comprises a static field magnet 104 that generates a uniform static magnetic field in an imaging space in which a subject 102 is placed, a gradient coil 106 that generates a gradient magnetic field in the imaging space, a radio frequency (RF) coil (transmit coil) 108 that generates a radio frequency magnetic field that generates a nuclear magnetic resonance signal (NMR signal) in atomic nuclei of atoms constituting a tissue of the subject 102, an RF probe (receive coil) 110 that detects the NMR signal generated from the subject 102, a radio frequency magnetic field generator 112, a gradient magnetic field power supply 114, a receiver 116, and a sequencer 118. The subject 102 is usually placed in the imaging space in a cylindrical gantry in a state of lying on a bed 103.

In the imaging space, an orthogonal tri-axial coordinate system is usually defined such that a direction of a central axis of the gantry is a Z-axis direction, a vertical direction is a Y-axis direction, and a direction orthogonal to both the Z-axis and the Y-axis is an X-axis direction.

The sequencer 118 transmits control information to the radio frequency magnetic field generator 112 and the gradient magnetic field power supply 114 in accordance with the imaging sequence. The radio frequency magnetic field generator 112 generates radio frequency current pulses at the Larmor frequency that cause nuclear magnetic resonance based on the control information input from the sequencer 118, and transmits the radio frequency current pulse to the transmit coil 108. The RF pulses corresponding to the radio frequency current pulses are transmitted from the transmit coil 108 to the subject 102.

The receive coil 110 detects the NMR signal generated by exciting the nuclear spins in the subject 102 by the RF pulses, and amplifies and transmits the detected NMR signal. The NMR signal is usually collected as a gradient echo or a spin echo, and is referred to as an echo signal herein.

The gradient coil 106 is composed of an X-axis gradient coil, a Y-axis gradient coil, and a Z-axis gradient coil that generate gradient magnetic fields Gx, Gy, and Gz in the X-axis direction, the Y-axis direction, and the Z-axis direction of the imaging space, respectively, and generates the gradient magnetic field corresponding to the current supplied from the gradient magnetic field power supply 114 in the imaging space.

The Z-axis gradient coil generates the gradient magnetic field Gz for selecting a slice position and a slice width of a plane of the subject 102 orthogonal to the Z-axis direction. The X-axis gradient coil generates the gradient magnetic field Gx proportional to the position in the X-axis direction as a readout direction (frequency encoding direction) gradient magnetic field during a period in which the echo signal is generated. The Y-axis gradient coil generates the phase encoding direction gradient magnetic field Gy having different intensities for each repetition time (TR).

The sequencer 118 controls each unit to operate at timing and intensity that are programmed in advance. Among the programs, particularly, a program that describes the timing and the intensity of the RF pulse, the gradient magnetic fields Gx, Gy, and Gz, and the signal reception is called an imaging sequence (pulse sequence).

Various pulse sequences are known depending on the purpose, and for example, a spin echo method and a gradient echo method are known, and various pulse sequences derived from these methods are known. Further, there is echo planar imaging (EPI), which is one of the high-speed imaging methods. In EPI, there are single-shot EPI, in which, during excitation by a single RF pulse, the gradient magnetic field is repeatedly reversed to generate a plurality of gradient echoes and fill k-space (the spatial-frequency domain) with the data required for image reconstruction, and multi-shot EPI, in which k-space is filled with echo-train data obtained over a plurality of shots.

The receive coil 110 illustrated in FIG. 1 receives the echo signal from the head of the subject 102, but is not limited to the receive coil that receives the echo signal from the head, and a receive coil corresponding to an examination part of the subject 102 such as the chest, the abdomen, the waist, the shoulder, and the hand and foot may be used and appropriately set. Further, there is also a flexible blanket type receive coil that is placed over the chest, the abdomen, and the waist.

The receiver 116 includes a preamplifier, a quadrature detection circuit, an analog-to-digital (A/D) converter, and the like, executes detection and A/D conversion of the echo signal detected by the receive coil 110, and transmits two steams of digital data of a real part and an imaginary part to the control device 200. The sequencer 118 transmits information on the nuclear magnetic resonance frequency (detection reference frequency) that is a reference for the quadrature detection performed by the receiver 116, a timing of the A/D conversion (sampling timing in the frequency encoding direction), and the like, and controls the receiver 116.

The control device 200 can be configured by using a computer. The computer applied to the control device 200 may be a personal computer or a workstation.

The control device 200 comprises a processor 202, a memory 204, an input/output interface 206, a display 208, an operation unit 210, and the like as hardware.

The processor 202 is configured by a central processing unit (CPU), integrally controls each unit of the control device 200 and the measurement unit 100, and executes various programs stored in the memory 204 and a trained model described later to implement various functions.

The memory 204 is one or more memories including a flash memory, a read-only memory (ROM), a random access memory (RAM), a hard disk device, and the like. The flash memory, the ROM, and the hard disk device are non-volatile memories that store an operation system, a program that causes the processor 202 to function as the control device 200, various pulse sequences, a calculation formula used for image reconstruction, parameters, the trained model, an MR image reconstructed by image reconstruction, and the like.

The RAM functions as a work area for processing by the processor 202, and temporarily stores the programs and the like stored in the non-volatile memory. The RAM functions as a place (k-space) that temporarily stores data (raw data) of the k-space in which each point (kₓ, k_{y}) in the k-space is filled with data indicating an amount of a spatial frequency component represented by each point (kₓ, k_{y}) in the k-space, which is obtained from the digital data of the real part and the digital data of the imaginary part of the echo signal that has been processed. The processor 202 may incorporate a portion (RAM) of the memory 204.

The input/output interface 206 includes a communication unit that is connectable to a network, a connection unit that is connectable to an external device, and the like. As the connection unit that is connectable to the external device, a universal serial bus (USB), a high-definition multimedia interface (HDMI) (HDMI is a registered trademark), and the like can be applied.

The processor 202 communicates with the device (in the present example, the sequencer 118) and the receiver 116 disposed in the measurement unit 100 via the input/output interface 206 to transmit and receive required information. A portion of the sequencer 118 may be provided on the control device 200 side.

The display 208 is used as a portion of a graphical user interface (GUI) in a case of receiving the MR image and the input from the operation unit 210.

The operation unit 210 includes a mouse, a keyboard, and the like, and functions as a portion of a GUI that receives the input from an operator by using a display operation window of the display 208.

That is, the operation unit 210 and the display 208 function as a GUI for the operator to activate and stop (pause) the measurement unit 100, select the pulse sequence, and input the imaging conditions, the processing conditions, and the like.

### Data of k-Space and MR Image in Real Space

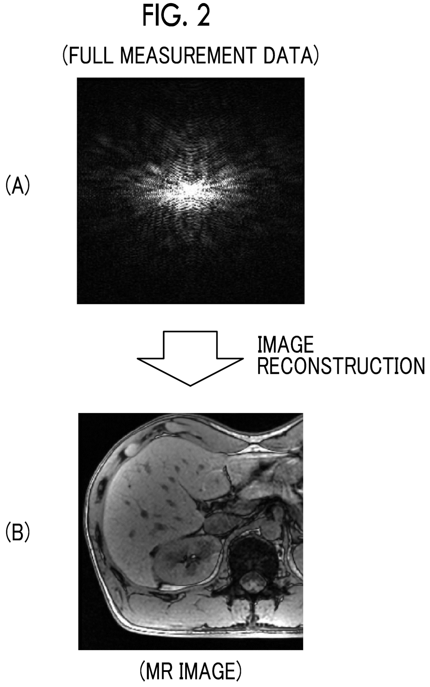

FIG. 2 is a diagram illustrating examples of the full measurement data of the k-space and the MR image reconstructed from the full measurement data.

The data of the k-space in the frequency space and the MR image in the real space have a relationship in which the data of the k-space in the frequency space and the MR image in the real space can be converted into each other by a Fourier transform and an inverse Fourier transform.

The data of the k-space is in the k-space with kₓ and k_{y} as axes, and kₓ and k_{y} represent spatial frequencies. The data near the origin of the k-space (portion in which the values of kₓ and k_{y} are small) has a low spatial frequency, and a component representing a rough structure of the image is present, and the data in a peripheral portion of the k-space (portion in which the value of kₓ or k_{y} is large) has a high spatial frequency, and a component representing a fine structure of the image is present.

In a case in which a matrix size of an effective field of view (FOV) of the subject to be imaged is set to 256 × 256, the data in the k-space is data (also referred to as "raw data") sampled at equal intervals (data pitch Δk) at 256 points × 256 points of the k-space. The upper and lower limits of the acquisition of the data in the k-space are determined in accordance with the spatial resolution of the MR image.

### Collection of Data of k-Space

The MRI apparatus 10 controls the sampling timing of the RF pulse, the gradient magnetic fields Gx, Gy, and Gz, and the echo signal generated from the transmit coil 108 in accordance with the pulse sequence selected depending on the examination part and the imaging purpose, and collects the data that fills the k-space.

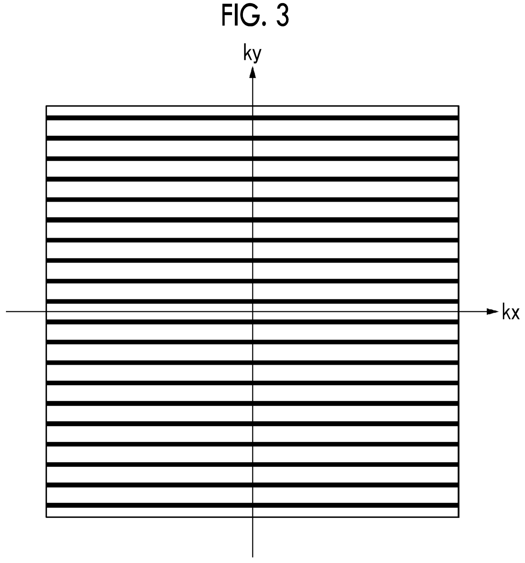

FIG. 3 is a diagram illustrating examples of each point (kₓ, k_{y}) of the data disposed in the k-space and a k-trajectory.

For example, in a case of the pulse sequence of the spin echo method, the gradient magnetic field Gx is generated in synchronization with the period during which the echo signal is generated, and the echo signal is sampled during the period, so that data for one line in the kₓ direction (frequency encoding direction) of the k-space is collected. The collection of the data for one line is performed for each repetition time TR. That is, the data of the kₓ direction (readout direction) of the k-space is collected in one echo.

The data in the k_{y} direction (phase encoding direction) is collected by changing the intensity of the gradient magnetic field Gy for each TR.

Therefore, it takes a time of TR × the number of steps of phase encoding to collect the full measurement data (for example, data of 256 points of sampling in the frequency encoding direction x the number of steps 256 in the phase encoding direction) that fills the k-space. In the pulse sequence of the spin echo method or the like, it takes several minutes to collect the full measurement data that fills the k-space as the imaging time.

In the related art, a half-Fourier method is used to reduce the imaging time. In the half-Fourier method, partial measurement data of a partially asymmetrical region in the k-space is measured without measuring the full measurement data that fills the k-space. For example, a half-scan measurement of reducing the number of steps in the phase encoding direction and a half-echo measurement of reducing the number of sampling points in the frequency encoding direction are known.

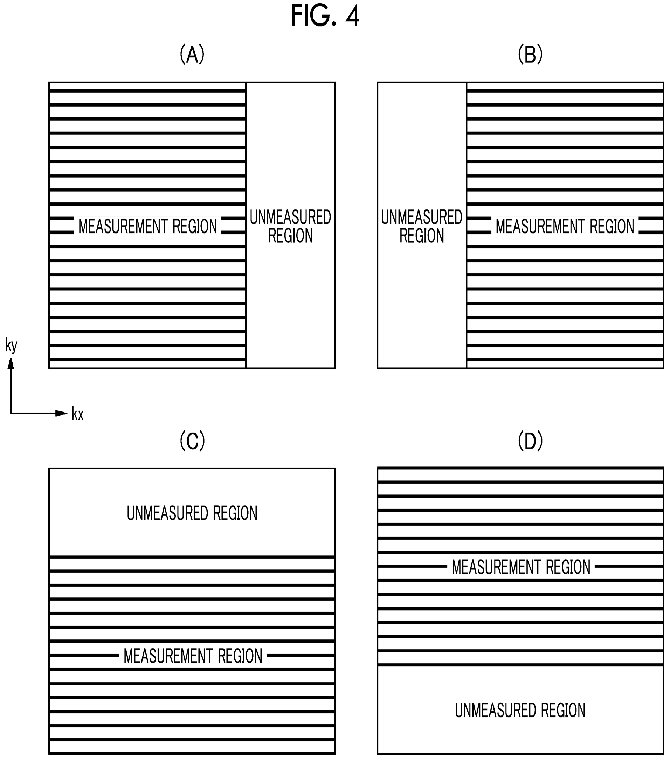

FIG. 4 is a diagram illustrating four patterns of the k-space having the partial measurement data of the asymmetrical region to which the half-Fourier method can be applied.

In the k-space of the pattern 1 illustrated in (A) of FIG. 4, an asymmetrical unmeasured region is present in the right direction (positive kₓ direction) among the four directions of the k-space, and the partial measurement data fills a region (measurement region) excluding the unmeasured region.

In the k-space of the pattern 2 illustrated in (B) of FIG. 4, the unmeasured region is present in the left direction (negative kₓ direction) of the k-space. In addition, in the k-space of the pattern 3 illustrated in (C) of FIG. 4, the unmeasured region is present in the up direction (positive k_{y} direction) of the k-space, and in the k-space of the pattern 4 illustrated in (D) of FIG. 4, the unmeasured region is present in the down direction (negative k_{y} direction) of the k-space.

In a case in which the k-space is filled with the partial measurement data collected by the half-echo method in which the number of sampling points in the frequency encoding direction is small, as in the k-space of the patterns 1 and 2 illustrated in (A) and (B) of FIG. 4, the collection time of the data of one line can be reduced, and particularly in a case in which the pulse sequence is EPI, the data of the k-space required for reconstructing one MR image can be collected in a shorter time.

In addition, in a case of the half-scan measurement in which the number of steps in the phase encoding direction is small, as in the k-space of the patterns 3 and 4 illustrated in (C) and (D) of FIG. 4, the number of phase encodings is reduced, and the imaging time can be reduced regardless of the type of the pulse sequence.

The pattern of the k-space to which the half-Fourier method can be applied is not limited to the four patterns illustrated in FIG. 4, and a k-space of a pattern in which both the half-scan measurement and the half-echo measurement are used and two adjacent regions among the asymmetrical regions in the four directions of the k-space are set as unmeasured regions may be used, and the measurement region of the k-space to which the half-Fourier method can be applied need only be a region exceeding one quadrant of a first quadrant to a fourth quadrant obtained by dividing the k-space into four quadrants.

### Method of Improving MR Image

A reconstruction image (MR image) reconstructed by performing an inverse Fourier transform on the data of the k-space to which the half-Fourier method illustrated in FIG. 4 can be applied, in which the zero data fills the unmeasured region, without using the half-Fourier method has degraded image quality due to the zero data filling the unmeasured region.

US2022/0198725A discloses a technique of improving the degradation of image quality of the MR image using a trained model (convolutional neural network (CNN)).

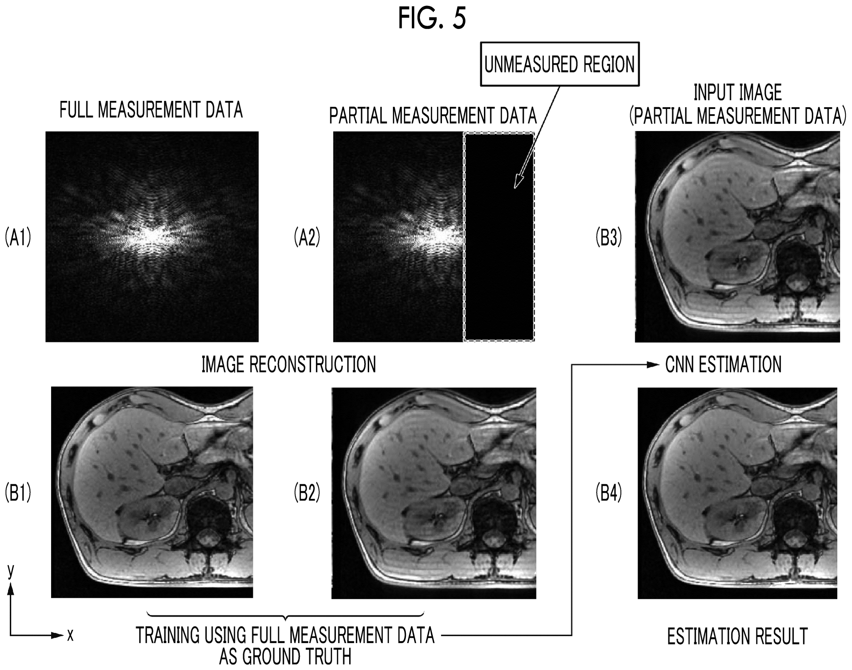

FIG. 5 is a conceptual diagram illustrating the method of improving the degradation of image quality of the MR image using the CNN.

First, a trained CNN that has been trained through machine learning using a pair of ground-truth data and a training image is prepared.

An image (first reconstruction image) reconstructed by performing an inverse Fourier transform on data ((A1) of FIG. 5) of a first k-space in which the entire region of the k-space (first k-space) is filled with the measurement data is set as the ground-truth data ((B1) of FIG. 5). In addition, data of a part of the first k-space of (A1) of FIG. 5 is replaced with zero data, the region is set as an asymmetrical unmeasured region (first unmeasured region), data ((A2) of FIG. 5) consisting of partial measurement data (first partial measurement data of a first measurement region) of a measurement region excluding the first unmeasured region and the zero data of the first unmeasured region is generated, an image reconstructed by performing an inverse Fourier transform on the data is set as a training image ((B2) of FIG. 5), and the CNN is trained through machine learning using a pair of the ground-truth data and the training image.

The number of training datasets used for the machine learning of the CNN is, for example, about 40,000. In addition, in the training dataset in a case in which one CNN is trained through machine learning, the directions of the first unmeasured regions of the first k-space corresponding to the respective training images need to be the same, and the proportions (first proportions) of the first unmeasured regions with respect to the entire region of the first k-space also need to be the same.

For example, since the direction of the first unmeasured region of the first k-space illustrated in (A2) of FIG. 5 is the right direction on FIG. 5, all the directions of the first unmeasured regions of the first k-space corresponding to the training images of the training dataset are set to the right direction. In addition, in a case in which the first proportion of the first unmeasured region with respect to the entire region of the first k-space is 40%, all the first proportions of the first unmeasured regions of the first k-space corresponding to the training images of the training dataset are also set to 40%.

In a case in which the partial measurement data (second partial measurement data) of the k-space (second k-space) to which the half-Fourier method can be applied is measured by the MRI apparatus, and the direction of the second unmeasured region of the second k-space and the proportion (second proportion) of the second unmeasured region with respect to the entire region of the second k-space match the direction of the first unmeasured region of the first k-space and the first proportion corresponding to the training image used for the trained CNN, an MR image reconstructed by performing an inverse Fourier transform on data of the second k-space consisting of the second partial measurement data of the second k-space and the zero data filling the second unmeasured region is set as an input image ((B3) of FIG. 5) for the CNN. Since the input image is an image reconstructed from the data of the k-space in which the zero data fills the second unmeasured region as described above, the image quality is degraded as compared with the MR image reconstructed from the full measurement k-space data.

The CNN to which the input image is input has a function of estimating and correcting the degradation of image quality due to noise or the like estimated from the input image, and outputs an image (estimation result) ((B4) of FIG. 5) in which the degradation of image quality is reduced with respect to the input image.

### Example of CNN

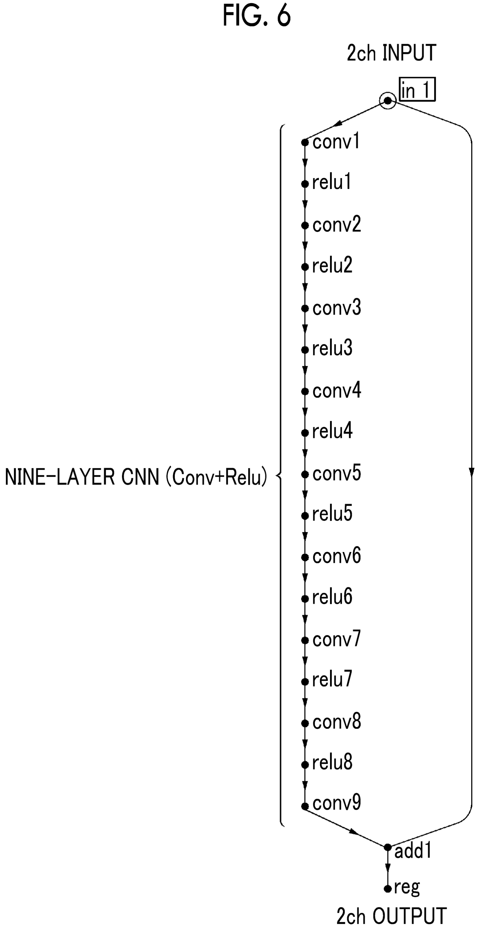

FIG. 6 is a diagram illustrating an example of the CNN applied as the trained model according to the embodiment of the present invention.

The CNN illustrated in FIG. 6 includes an input layer (in1), nine convolutional layers (Conv), eight rectified linear units (Relu), an add layer, and a reg layer.

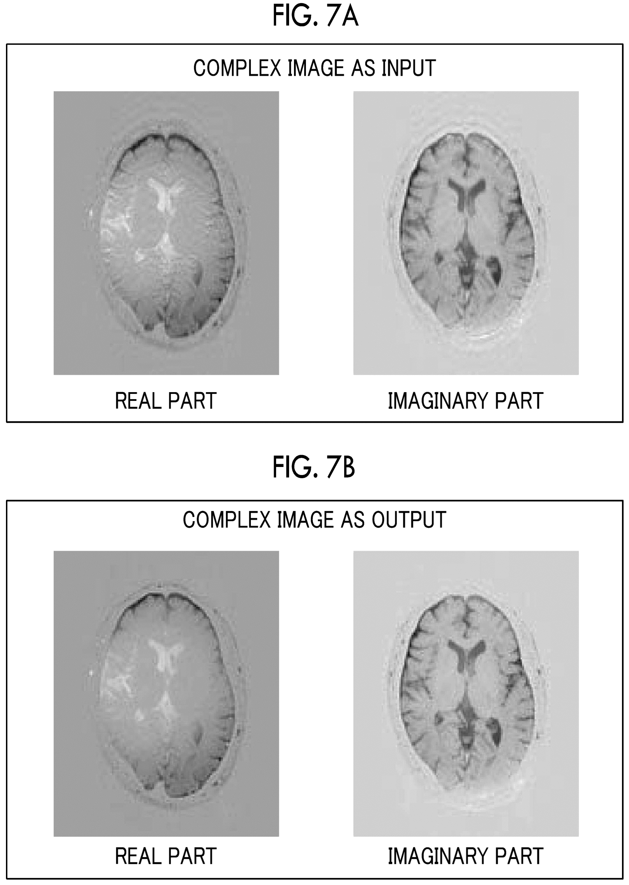

FIG. 7 is a diagram illustrating an example of the input image and the output image of the CNN illustrated in FIG. 6.

As illustrated in FIG. 7A, a complex image of two channels of the real part and the imaginary part is input to the input layer (in1) of the CNN illustrated in FIG. 6.

The measurement data measured by the MRI apparatus is complex data, and the data of the real part and the data of the imaginary part are disposed in the real part k-space and the imaginary part k-space, respectively. The complex image of two channels illustrated in FIG. 7A is an image of the real part obtained by performing an inverse Fourier transform on the data of the real part k-space and an image of the imaginary part obtained by performing an inverse Fourier transform on the data of the imaginary part k-space. The complex image of two channels illustrated in FIG. 7A is an image reconstructed from the complex data of the real part and the imaginary part of the k-space in which the proportion of the unmeasured region with respect to the entire region in the k-space is 40%.

The CNN estimates the degradation of image quality of the complex image with respect to the complex image of two channels input to the input layer (in1) through the nine Conv and the eight Relu, and outputs two-channel correction information for correcting the degradation of image quality to the add layer. The complex image of two channels input to the input layer (in1) is added to the other input of the add layer, and the add layer adds the complex image of two channels input to the input layer (in1) and the two-channel correction information to output the complex image of two channels in which the degradation of image quality is reduced (FIG. 7B) as the output image to the reg layer.

The number of convolutional layers and the number of rectified linear units of the CNN are not limited to the embodiment illustrated in FIG. 6, and the CNN may not have an add layer or may have a pooling layer, and various CNNs having various layer structures can be applied to the MRI apparatus 10. Furthermore, the trained model applied to the MRI apparatus 10 is not limited to the CNN, and may be another neural network such as a fully convolutional network (FCN) or a recurrent neural network (RNN), and any learning model may be used as long as the learning model is trained by a dataset for machine learning.

### Method of Creating Training Image Set

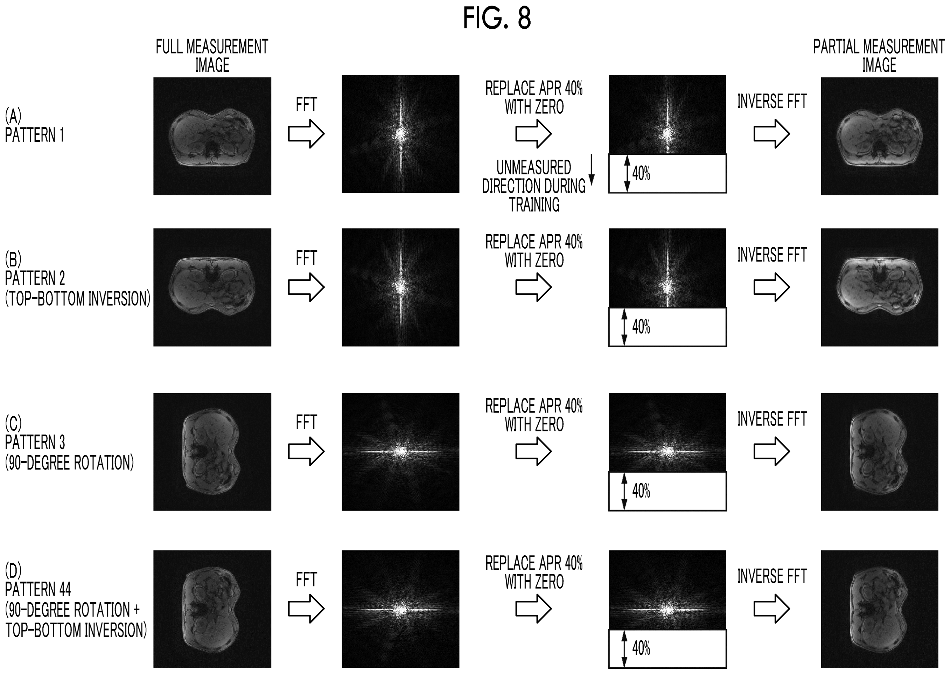

FIG. 8 is a diagram illustrating a method of creating the training image set for training the CNN corresponding to the four patterns in which the directions of the asymmetrical unmeasured regions of the k-space are different from each other.

(A) of FIG. 8 is a diagram illustrating the method of creating the training image set for training the CNN that reduces the degradation of image quality of the MR image reconstructed from the data of the k-space corresponding to the direction of the pattern 1, in which the direction of the asymmetrical unmeasured region of the k-space is the pattern 1.

The full measurement image illustrated in (A) of FIG. 8 is the full measurement image reconstructed from the full measurement data in the k-space, and is used as the ground-truth data as it is.

Meanwhile, the training image (partial measurement image) paired with the ground-truth data is created as follows.

The preset asymmetrical unmeasured region of the k-space obtained by performing a Fourier transform on the full measurement image illustrated in (A) of FIG. 8 is filled with zero data. That is, the measurement data corresponding to the preset unmeasured region of the full measurement data in the k-space is replaced with the zero data.

In a case of the pattern 1, the direction of the asymmetrical unmeasured region of the k-space is the down direction on FIG. 8, and the proportion of the unmeasured region to the entire region of the k-space is 40%. The partial measurement image reconstructed by performing a Fourier transform on the data of the k-space generated in this way is set as the training image.

The full measurement image illustrated in (B) of FIG. 8 is a top-bottom inverted image obtained by performing top-bottom inversion on the full measurement image illustrated in (A) of FIG. 8, and the top-bottom inverted image is set as the ground-truth data.

The preset asymmetrical unmeasured region of the full measurement data in the k-space obtained by performing a Fourier transform on the top-bottom inverted image is filled with zero data.

In a case of the pattern 2, the direction of the asymmetrical unmeasured region of the top-bottom inverted k-space is the down direction on FIG. 8, and the proportion of the unmeasured region to the entire region of the k-space is 40%. The partial measurement image reconstructed by performing a Fourier transform on the data of the k-space generated in this way is set as the training image.

The full measurement image illustrated in (C) of FIG. 8 is a 90-degree rotated image obtained by rotating the full measurement image illustrated in (A) of FIG. 8 by 90 degrees clockwise, and the 90-degree rotated image is set as the ground-truth data.

The preset asymmetrical unmeasured region of the full measurement data in the k-space obtained by performing a Fourier transform on the 90-degree rotated image is filled with zero data.

In a case of the pattern 3, the direction of the asymmetrical unmeasured region of the 90-degree rotated k-space is the down direction on FIG. 8, and the proportion of the unmeasured region to the entire region of the k-space is 40%. The partial measurement image reconstructed by performing a Fourier transform on the data of the k-space generated in this way is set as the training image.

The full measurement image illustrated in (D) of FIG. 8 is an image (90-degree rotation + top-bottom inversion) obtained by further performing top-bottom inversion on the 90-degree rotated image illustrated in (C) of FIG. 8, and the image is set as the ground-truth data.

The preset asymmetrical unmeasured region of the full measurement data in the k-space obtained by performing a Fourier transform on the full measurement image illustrated in (D) of FIG. 8 is filled with zero data.

In a case of the pattern 4, the direction of the asymmetrical unmeasured region of the 90-degree rotated and top-bottom inverted k-space is the down direction on FIG. 8, and the proportion of the unmeasured region to the entire region of the k-space is 40%. The partial measurement image reconstructed by performing a Fourier transform on the data of the k-space generated in this way is set as the training image.

With the method of creating the training image set, as illustrated in (A) to (D) of FIG. 8, the training image sets corresponding to the patterns 1 to 4 can be created from one full measurement image.

In addition, the training image sets illustrated in the patterns 1 to 4 has the proportion of the unmeasured region with respect to the entire region of the k-space as 40%, but the training image set can be created in the same manner even in a case in which the proportion of the unmeasured region is set to a value other than 40%.

Furthermore, in the example illustrated in FIG. 8, the full measurement data of the k-space corresponding to the full measurement image is acquired by performing a Fourier transform on the full measurement image corresponding to the patterns 1 to 4, but in a case in which the full measurement data in the k-space acquired during the imaging is stored, the stored full measurement data may be top-bottom inverted and/or rotated by 90 degrees to acquire the full measurement data in the k-space corresponding to the patterns 1 to 4.

### Processor

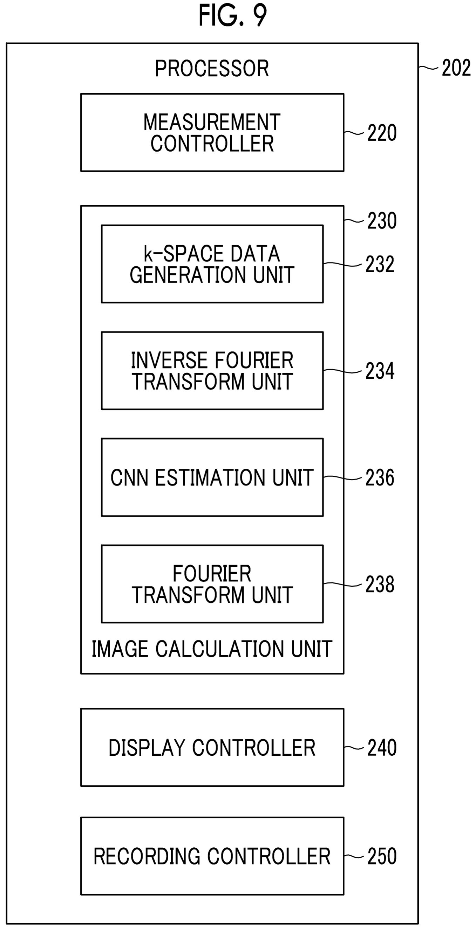

FIG. 9 is a functional block diagram illustrating functions of the processor of the control device illustrated in FIG. 1.

As illustrated in FIG. 9, the processor 202 executes various programs and the trained model (CNN) stored in the memory 204 to function as a measurement controller 220, an image calculation unit 230, a display controller 240, and a recording controller 250.

The CNN stored in the memory 204 is, for example, a trained CNN trained using the training image sets corresponding to the patterns 1 to 4 created by the method of creating the training image set illustrated in FIG. 8.

The measurement controller 220 transmits a predetermined pulse sequence, the imaging conditions (imaging parameters) designated by the operator, and the like to the sequencer 118 (FIG. 1) of the measurement unit 100, and controls the measurement unit 100 via the sequencer 118. In the present example, the sequence for performing the half-scan measurement of reducing the number of steps in the phase encoding direction and/or the half-echo measurement of reducing the number of sampling points in the frequency encoding direction is selected. In addition, the proportion of the asymmetrical unmeasured region of the k-space in a case of performing the half-scan measurement or the half-echo measurement is set to any of 1% to 45% by the operator, and the direction of the unmeasured region is also set by the operator.

The measurement controller 220 transmits a command to the sequencer 118 in accordance with the set conditions, and causes the measurement unit 100 to execute the pulse sequence under the control of the sequencer 118. The subject 102 is imaged by executing the pulse sequence by the measurement unit 100, and the receive coil 110 provided at the examination part of the subject 102 receives the echo signal from the subject 102. The receiver 116 executes the detection and the A/D conversion of the echo signal received by the receive coil 110, and transmits the digital data of the real part and the imaginary part to the control device 200 via the input/output interface 206.

The image calculation unit 230 of the processor 202 includes a k-space data generation unit 232, an inverse Fourier transform unit 234, a CNN estimation unit 236, a Fourier transform unit 238, and the like.

The k-space data generation unit 232 arranges the digital data of the real part and the imaginary part, which are data (k-space data) sequentially collected from the echo signal along the k-trajectory, in the k-space (second k-space). In a case in which the size of the FOV is set to 256 pixels × 256 pixels, the entire region of the second k-space also has a size of 256 × 256, but the data of the asymmetrical second unmeasured region obtained by the half-scan measurement or the half-echo measurement is not collected from the entire region of the second k-space, and the k-space data generation unit 232 acquires the second partial measurement data of the measurement region (second measurement region) excluding the second unmeasured region arbitrarily set for the second k-space and arranges the second partial measurement data in the second k-space, and fills the second unmeasured region with the zero data to generate the data of the second k-space.

It goes without saying that, in a case in which the entire region of the second k-space before the second partial measurement data is arranged is filled with the zero data, it is not necessary to perform the processing of filling the second unmeasured region with the zero data. Further, the k-space data generation unit 232 generates not only the data of the second k-space but also the data of a plurality of k-spaces such as a third k-space, a fourth k-space, and the like, but details of the data of these k-spaces will be described later.

The inverse Fourier transform unit 234 is a unit that performs an inverse Fourier transform (inverse fast Fourier transform (FFT)) in the data of the k-space (including the second k-space) generated by the k-space data generation unit 232 to convert the data into an image (MR image) in the real space.

The CNN estimation unit 236 is a unit that uses the CNN stored in the memory 204 to estimate and correct the degradation of image quality caused by the zero data of the unmeasured region with respect to the input image (complex image) of the CNN as described with reference to FIGS. 6 and 7, and outputs an image (complex image) in which the degradation of image quality is reduced with respect to the input complex image.

The Fourier transform unit 238 is a unit that performs a Fourier transform (FFT) on the complex image in which the degradation of image quality is reduced to generate the data of the k-space, and functions as a portion of the k-space data generation unit 232.

The display controller 240 displays the MR image calculated by the image calculation unit 230 and necessary accessory information (for example, information on the imaging conditions or the subject 102) on the display 208 (FIG. 1), and displays the MR image and the like recorded in the memory 204 on the display 208.

The recording controller 250 records the MR image with the accessory information in, for example, a medical image format of digital imaging and communications in medicine (DICOM) in the memory 204. The MR image in this case is recorded as a sum-of-squares image of the complex image.

### First Embodiment of MRI Apparatus

Next, a first embodiment of the MRI apparatus according to the embodiment of the present invention will be described.

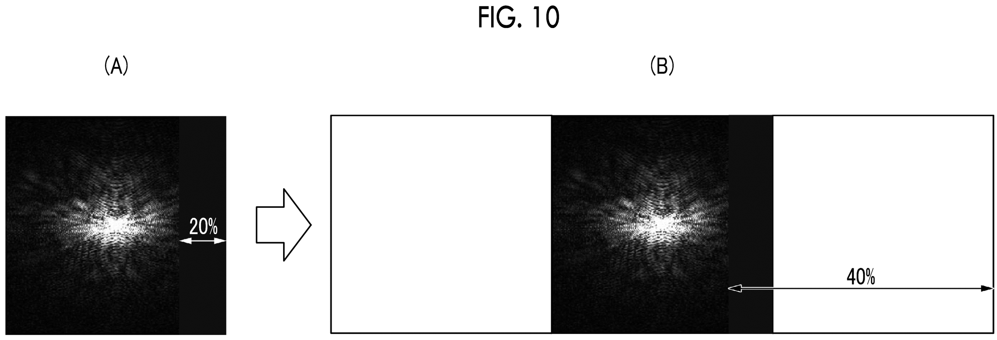

FIG. 10 is a diagram illustrating the first embodiment of the MRI apparatus according to the embodiment of the present invention, and is a diagram particularly illustrating some functions of the k-space data generation unit 232 of the processor 202 illustrated in FIG. 9.

(A) of FIG. 10 is a diagram illustrating an example of the k-space data (second k-space data) generated by the k-space data generation unit 232.

The k-space data generation unit 232 acquires the partial measurement data (second partial measurement data) of the measurement region (second measurement region) excluding the asymmetrical unmeasured region (second unmeasured region) arbitrarily set for the second k-space from the measurement unit 100.

The pattern of the second k-space illustrated in (A) of FIG. 10 is a pattern in which the asymmetrical second unmeasured region is present in the right direction (positive kₓ direction) of the second k-space as in the pattern 1 of the k-space illustrated in (A) of FIG. 4, and the proportion (second proportion) of the second unmeasured region with respect to the entire region of the second k-space is 20%.

Here, the pattern of the second k-space (that is, the direction of the asymmetrical second unmeasured region and the second proportion of the second unmeasured region) can be arbitrarily set by the operator. The half-Fourier method installed in the MRI apparatus supports the unmeasured percentage (second proportion) from 1% to 45% in 1% increments, so it is preferable that the second proportion is set in a range of 1% to 45%.

The MRI apparatus 10 executes the imaging by the pulse sequence corresponding to the set pattern of the second k-space (in the present example, the pattern of the second k-space illustrated in (A) of FIG. 10), and the k-space data generation unit 232 acquires the second partial measurement data of the second k-space from the measurement unit 100.

The k-space data generation unit 232 arranges the second partial measurement data acquired from the measurement unit 100 in the second measurement region of the second k-space, and fills the second unmeasured region of the second k-space with the zero data to generate the data of the second k-space. In a case in which the zero data fills the entire region of the second k-space in advance, the data of the second k-space can be generated by arranging the second partial measurement data in the second measurement region of the second k-space.

In addition, it is assumed that the memory 204 illustrated in FIG. 1 stores four CNNs (also referred to as "40% CNNs") corresponding to the four patterns in which the first proportion of the first unmeasured region with respect to the entire region of the first k-space is 40% and the direction of the first unmeasured region corresponds to the four directions.

In a case in which the second proportion of the second unmeasured region of the generated data of the second k-space is different from the first proportion of the first unmeasured region with respect to the entire region of the first k-space corresponding to the training image used for training the CNN, the k-space data generation unit 232 generates the data of the third k-space ((B) of FIG. 10) by filling the outer region of the second k-space with the zero data such that the second proportion becomes the first proportion.

In the present example, since the second proportion of the second unmeasured region of the second k-space illustrated in (A) of FIG. 10 is 20% and the first proportion of the first unmeasured region with respect to the entire region of the first k-space corresponding to the training image used for training the 40% CNN is 40%, the k-space data generation unit 232 generates the data of the third k-space by adding regions having the same size and filled with the zero data to the outer regions of the second k-space (outer regions in two directions of the right side and the left side) as illustrated in (B) of FIG. 10.

In a case in which the vertical and horizontal sizes of the second k-space illustrated in (A) of FIG. 10 are 256 × 256, the k-space data generation unit 232 generates the third k-space having a size of 256 × 768 by adding regions in which the zero data of 256 × 256 fills the outer region of the second k-space.

Accordingly, the size of the unmeasured region on the right side of the partial measurement data arranged in the third k-space with respect to the entire region of the third k-space having a size of 256 × 768 is 256 × 307.2, and the proportion of the region of 256 × 307.2 with respect to the region of 256 × 768 is 40%. Here, 307.2 = 256 × 0.2 + 256, 256 × 0.2 is a horizontal size of the second unmeasured region of the second k-space illustrated in (A) of FIG. 10, and 256 is a horizontal size of the region filled with the zero data added to the outer region of the second k-space.

In a case in which the second proportion of the second unmeasured region with respect to the entire region of the second k-space is different from the first proportion of the first unmeasured region with respect to the entire region of the first k-space, the k-space data generation unit 232 can generate the data of the third k-space in which the proportion of the unmeasured region is the first proportion by filling the outer region of the second k-space with the zero data.

### Second Embodiment of MRI Apparatus

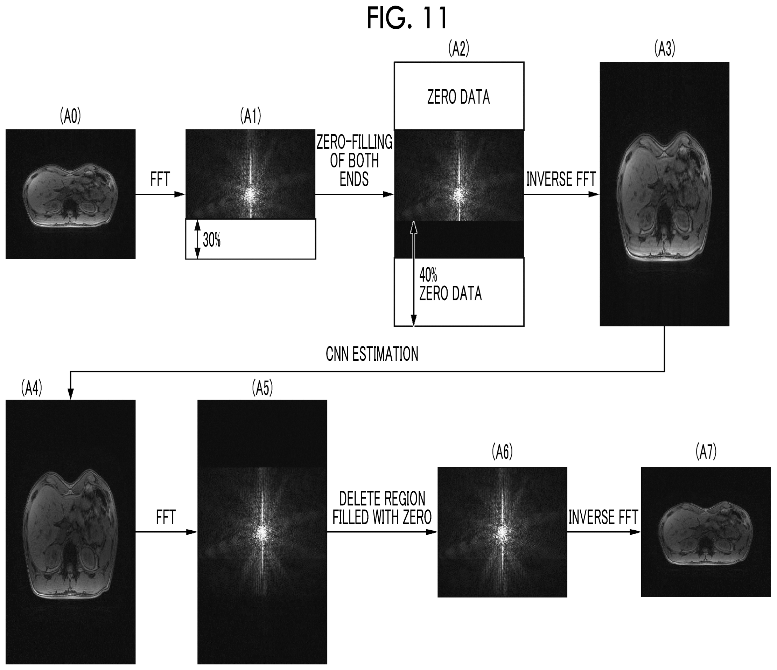

FIG. 11 is a diagram illustrating a second embodiment of the MRI apparatus according to the embodiment of the present invention, and is a diagram particularly illustrating some functions of the image calculation unit 230 of the processor 202 illustrated in FIG. 9.

(A1) and (A2) of FIG. 11 are diagrams corresponding to (A) and (B) of FIG. 10 described above. However, the k-space illustrated in (A1) of FIG. 11 is different from the k-space illustrated in (A) of FIG. 10 in that the asymmetrical second unmeasured region is present in the down direction (negative k_{y} direction) of the second k-space and the second proportion of the second unmeasured region with respect to the entire region of the second k-space is 30%.

The k-space data generation unit 232 acquires the second partial measurement data of the second measurement region excluding the asymmetrical second unmeasured region arbitrarily set for the second k-space from the measurement unit 100 ((A1) of FIG. 11). (AO) of FIG. 11 is an image obtained by performing an inverse Fourier transform on the data of the k-space illustrated in (A1) of FIG. 11, and conversely, in a case in which the image of (A0) of FIG. 11 is subjected to a Fourier transform (FFT), the data of the k-space illustrated in (A1) of FIG. 11 is obtained.

The k-space data generation unit 232 arranges the second partial measurement data acquired from the measurement unit 100 in the second measurement region of the second k-space, and fills the second unmeasured region of the second k-space with the zero data to generate the data of the second k-space ((A1) of FIG. 11). In a case in which the zero data fills the entire region of the second k-space in advance, the data of the second k-space can be generated by arranging the second partial measurement data in the second measurement region of the second k-space.

In a case in which the second proportion (in the example illustrated in (A1) of FIG. 11, 30%) of the second unmeasured region of the generated data of the second k-space is different from the first proportion (40%) of the first unmeasured region with respect to the entire region of the first k-space corresponding to the training image used for training the 40% CNN, the k-space data generation unit 232 generates the data of the third k-space ((A2) of FIG. 11) by filling the outer region of the second k-space with the zero data such that the second proportion (30%) becomes the first proportion (40%).

In the present example, since the second proportion of the second unmeasured region of the second k-space illustrated in (A1) of FIG. 11 is 30%, the 40% CNN cannot be used. Therefore, the k-space data generation unit 232 generates the data of the third k-space by adding regions having the same size and in which the outer region of the second k-space (outer region in two directions of the upper side and the lower side) is filled with the zero data as illustrated in (A2) of FIG. 11.

In a case in which the vertical and horizontal sizes of the second k-space illustrated in (A1) of FIG. 11 are 256 × 256, the k-space data generation unit 232 generates the data of the third k-space having a size of 512 × 256 by adding regions in which the outer region of the second k-space is filled with the zero data of 128 × 256.

As a result, the size of the unmeasured region below the partial measurement data arranged in the third k-space is 204.8 × 256, and the proportion of the unmeasured region of 204.8 × 256 with respect to the entire region of the third k-space having a size of 512 × 256 is 40%. Here, 204.8 = 256 × 0.3 + 128, 256 × 0.3 is a vertical size of the second unmeasured region of the second k-space illustrated in (A1) of FIG. 11, and 128 is a vertical size of the region filled with the zero data added to the outer region of the second k-space.

In a case in which the second proportion of the second unmeasured region with respect to the entire region of the second k-space is different from the first proportion of the first unmeasured region with respect to the entire region of the first k-space, the k-space data generation unit 232 can generate the data of the third k-space in which the proportion of the unmeasured region is the first proportion by filling the outer region of the second k-space with the zero data.

The inverse Fourier transform unit 234 generates the MR image (third reconstruction image) by performing an inverse Fourier transform on the data ((A2) of FIG. 11) of the third k-space ((A3) of FIG. 11). The size of the third reconstruction image is 512 × 256, which is the same as the size of the third k-space.

The CNN estimation unit 236 inputs the third reconstruction image illustrated in (A3) of FIG. 11 as the input image of the trained model (40% CNN trained using a pair of the full measurement image and the partial measurement image illustrated in (D) of FIG. 8), and acquires the output image from the 40% CNN as an intermediate image ((A4) of FIG. 11). The intermediate image illustrated in (A4) of FIG. 11 is an image in which the degradation of image quality due to the zero data of the second unmeasured region of the second k-space is estimated and corrected by the 40% CNN, and thus the degradation of image quality is reduced with respect to the third reconstruction image that is the input image.

The Fourier transform unit 238 generates the data of the fourth k-space by performing a Fourier transform on the intermediate image illustrated in (A4) of FIG. 11 ((A5) of FIG. 11). The k-space data generation unit 232 generates the data of the fifth k-space by deleting a region corresponding to the zero data (see (A2) of FIG. 11) filling the outer region of the third k-space from the generated data of the fourth k-space ((A6) of FIG. 11). This fifth k-space has a size of 256 × 256.

The inverse Fourier transform unit 234 generates the MR image (final output image) by performing an inverse Fourier transform on the data ((A6) of FIG. 11) of the fifth k-space ((A7) of FIG. 11). The size of the final output image is 256 × 256, which is the same as the fifth k-space.

The final image illustrated in (A7) of FIG. 11 is an image in which the CNN estimation result is reflected, and thus the degradation of image quality is reduced as compared with the image ((A0) of FIG. 11) obtained by performing an inverse Fourier transform on the data of the second k-space illustrated in (A1) of FIG. 11.

As described above, the image calculation unit 230 calculates the final image consisting of the complex image of the real part and the imaginary part based on the data of the k-space of the real part and the imaginary part, and calculates the sum-of-squares image of the complex image.

The recording controller 250 of the processor 202 usually records the sum-of-squares image (MR image) of the complex image calculated by the image calculation unit 230 in the memory 204 or the like.

According to the second embodiment of the MRI apparatus, even in a case in which the second proportion of the second unmeasured region with respect to the entire region of the second k-space is less than the first proportion of the first unmeasured region with respect to the entire region of the first k-space, the common CNN trained to correspond to the data of the first k-space can be applied to the CNN estimation, and thus the number of CNNs to be prepared can be reduced.

### Third Embodiment of MRI Apparatus

Next, a third embodiment of the MRI apparatus according to the embodiment of the present invention will be described.

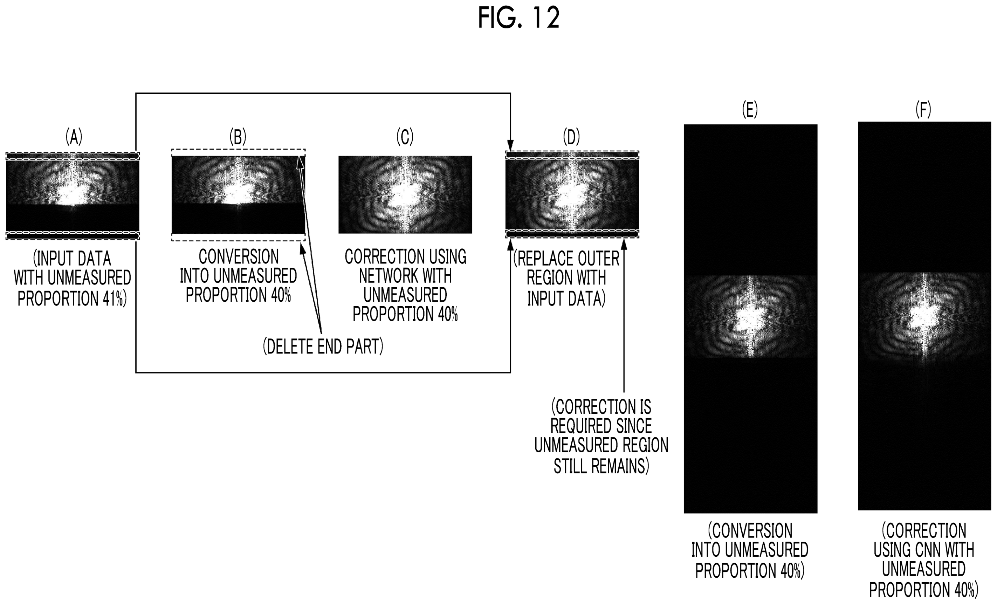

FIG. 12 is a diagram illustrating the third embodiment of the MRI apparatus according to the embodiment of the present invention, and is a diagram particularly illustrating some functions of the image calculation unit 230 of the processor 202 illustrated in FIG. 9.

(A) of FIG. 12 is a diagram illustrating an example of the k-space data (second k-space data) generated by the k-space data generation unit 232.

The k-space data generation unit 232 acquires the second partial measurement data of the second measurement region excluding the asymmetrical second unmeasured region arbitrarily set for the second k-space from the measurement unit 100.

The pattern of the second k-space illustrated in (A) of FIG. 12 is a pattern in which the asymmetrical second unmeasured region is present in the down direction (negative k_{y} direction) of the second k-space as in the pattern 4 of the k-space illustrated in (D) of FIG. 4, and the second proportion of the second unmeasured region with respect to the entire region of the second k-space is 41%.

The MRI apparatus 10 executes the imaging by the pulse sequence corresponding to the set pattern of the second k-space (in the present example, the pattern of the second k-space illustrated in (A) of FIG. 12), and the k-space data generation unit 232 acquires the second partial measurement data of the second k-space from the measurement unit 100.

The k-space data generation unit 232 arranges the second partial measurement data acquired from the measurement unit 100 in the second measurement region of the second k-space, and fills the second unmeasured region of the second k-space with the zero data to generate the data of the second k-space. In a case in which the zero data fills the entire region of the second k-space in advance, the data of the second k-space can be generated by arranging the second partial measurement data in the second measurement region of the second k-space.

In addition, it is assumed that the memory 204 illustrated in FIG. 1 stores the trained CNNs (40% CNNs) corresponding to the four patterns in which the first proportion of the first unmeasured region with respect to the entire region of the first k-space is 40% and the direction of the first unmeasured region corresponds to the four directions.

In a case in which the second proportion (in the example illustrated in (A) of FIG. 12, 41%) of the second unmeasured region of the generated data of the second k-space is different from the first proportion (in the present example, 40%) of the first unmeasured region with respect to the entire region of the first k-space corresponding to the training image used for training the 40% CNN, the k-space data generation unit 232 generates the data of the third k-space ((B) of FIG. 12) by deleting the data of the outer end part of the second k-space such that the second proportion (41%) becomes the first proportion (40%).

In the present example, since the second proportion of the second unmeasured region of the second k-space illustrated in (A) of FIG. 12 is 41%, the 40% CNN cannot be used. Therefore, the k-space data generation unit 232 generates the data of the third k-space in which the 40% CNN can be used by deleting the data of the outer region of the second k-space (outer region in two directions of the upper side and the lower side) having the same size as illustrated in (B) of FIG. 12.

In a case in which the vertical and horizontal sizes of the second k-space illustrated in (A) of FIG. 12 are 128 × 256, the k-space data generation unit 232 generates the third k-space having a size of 116 × 256 by deleting the data of the outer region of the second k-space by a size of 6 × 128.

As a result, the size of the unmeasured region below the partial measurement data arranged in the third k-space with respect to the entire region of the third k-space having a size of 116 × 256 is 46.48 × 256, and the proportion of the region of 46.48 × 256 with respect to the region of 116 × 256 is 40.1%. Here, 46.48 = 128 × 0.41 - 6, 128 × 0.41 is a vertical size of the second unmeasured region of the second k-space illustrated in (A) of FIG. 12, and 6 is a vertical size of the deleted region of the outer region of the second k-space.

The inverse Fourier transform unit 234 generates the MR image (third reconstruction image) by performing an inverse Fourier transform on the data ((B) of FIG. 12) of the third k-space. In this case, the size of the third reconstruction image is 116 × 256.

The CNN estimation unit 236 uses the 40% CNN, inputs the third reconstruction image as the input image of the 40% CNN, and acquires the output image from the 40% CNN as the intermediate image (first intermediate image). The Fourier transform unit 238 generates the data of the k-space by performing a Fourier transform on the first intermediate image estimated by the CNN ((C) of FIG. 12). In this case, the size of the k-space is 116 × 256.

Next, the k-space data generation unit 232 generates the data of the fourth k-space by adding the deleted data to the outer region of the data of the k-space illustrated in (C) of FIG. 12 as indicated by the arrow. The size of the fourth k-space is the same as the size (128 × 256) of the second k-space.

In addition, the unmeasured region filled with the zero data remains at a lower end part of the fourth k-space. The size of the unmeasured region (fourth unmeasured region) at the lower end part of the fourth k-space in the present example is 6 × 256, and the proportion (fourth proportion) of the fourth unmeasured region with respect to the entire region of the fourth k-space is 6/256, which is less than 40%.

Therefore, in the same manner as in the first embodiment and the second embodiment, in order to enable the correction by the 40% CNN, the k-space data generation unit 232 generates the data of the fifth k-space in which the proportion of the unmeasured region is 40% by adding regions having the same size and filled with the zero data to the outer region of the fourth k-space (outer region in two directions of the upper side and the lower side) as illustrated in (D) of FIG. 12 ((E) of FIG. 12).

That is, the k-space data generation unit 232 generates the data of the fifth k-space having a size of 580 × 256 by adding regions in which the zero data of 226 × 256 fills the outer region of the fourth k-space illustrated in (D) of FIG. 12.

As a result, the size of the unmeasured region below the partial measurement data arranged in the fifth k-space with respect to the entire region of the fifth k-space having a size of 580 × 256 is 232 × 256, and the proportion of the region of 232 × 256 with respect to the region of 580 × 256 is 40%. Here, 580 is a vertical size of the region filled with the zero data added to the outer region of the fourth k-space, and 580 = 128 + 226 × 2. In addition, 234 is a value obtained by adding the vertical size (= 6) of the unmeasured region illustrated in (D) of FIG. 12 and the vertical size (= 226) of the region filled with the zero data.

(F) of FIG. 12 illustrates the data of the sixth k-space after correction obtained by correcting the data of the fifth k-space illustrated in (E) of FIG. 12 using the 40% CNN. That is, the data of the fifth k-space and the data of the sixth k-space illustrated respectively in (E) and (F) of FIG. 12 have the same relationship as the data of the third k-space and the data of the fourth k-space illustrated respectively in (A2) and (A5) of FIG. 11. In FIG. 12, processing such as an inverse Fourier transform on the data of the fifth k-space illustrated in (E) of FIG. 12, the correction of the fifth reconstruction image after a Fourier transform by the 40% CNN, a sixth reconstruction image after the correction, and a Fourier transform of the sixth reconstruction image is omitted, and (F) of FIG. 12 illustrates the data of the sixth k-space after a Fourier transform on the sixth reconstruction image after the above-described processing.

In addition, the data of the sixth k-space illustrated in (F) of FIG. 12 is subjected to the deletion of the region filled with the zero data, and the data of the k-space (seventh k-space) after the deletion is subjected to an inverse Fourier transform, thereby generating the output image (final image).

According to the third embodiment of the MRI apparatus 10, even in a case in which the second proportion of the second unmeasured region with respect to the entire region of the second k-space is greater than the first proportion of the first unmeasured region with respect to the entire region of the first k-space, the common CNN trained to correspond to the data of the first k-space can be applied to the CNN estimation, and thus the number of CNNs to be prepared can be reduced.

### Fourth Embodiment of MRI Apparatus

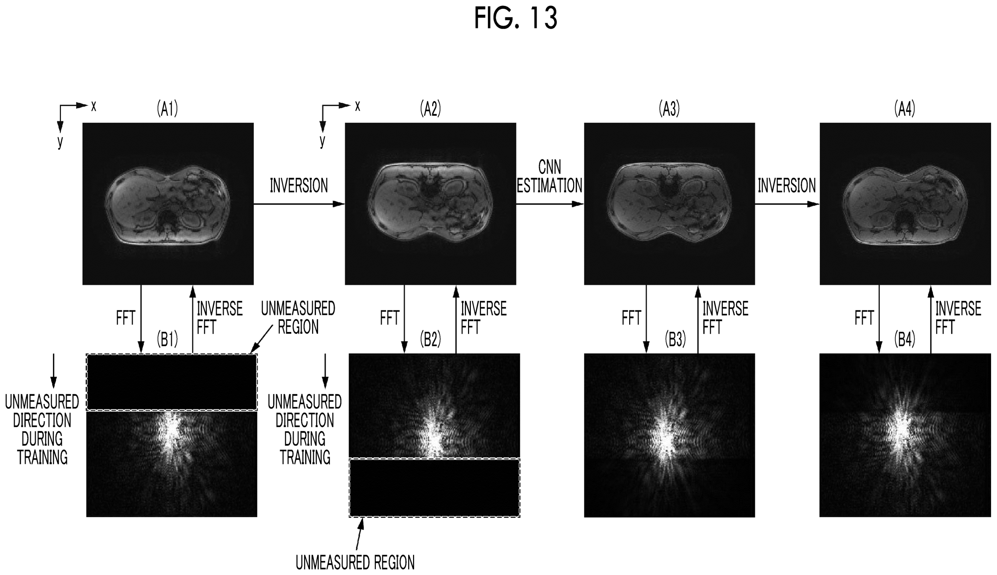

FIG. 13 is a diagram illustrating a fourth embodiment of the MRI apparatus according to the embodiment of the present invention, and is a diagram illustrating an embodiment in which the common CNN can be applied to data of the plurality of k-spaces in which the directions of the unmeasured regions of the k-space are different from each other.

The memory 204 illustrated in FIG. 1 stores four 40% CNNs corresponding to the four patterns in which the first proportion of the first unmeasured region with respect to the entire region of the first k-space is 40% and the direction of the first unmeasured region corresponds to the four directions, but, in the fourth embodiment described later, one 40% CNN corresponding to a specific one direction (specific direction) in relation to the direction of the unmeasured region can be commonly used even in a case in which the direction of the unmeasured region is different from the specific direction, thereby reducing the number of 40% CNNs and reducing the training time.

(A1) to (A4) of FIG. 13 are diagrams illustrating the reconstruction images, and (B1) to (B4) of FIG. 13 are diagrams illustrating the k-space data obtained by performing a Fourier transform on the reconstruction images illustrated in (A1) to (A4) of FIG. 13, respectively. On the contrary, (A1) to (A4) of FIG. 13 are the reconstruction images obtained by performing an inverse Fourier transform on the data of the k-space illustrated in (B1) to (B4) of FIG. 13, respectively.

In a case in which the data of the k-space in which the direction of the unmeasured region is the up direction illustrated in (B1) of FIG. 13 is acquired, the reconstruction image illustrated in (A1) of FIG. 13 can be generated by performing an inverse Fourier transform on the data of the k-space.

On the other hand, as illustrated in (B2) of FIG. 13, in a case in which the 40% CNN is generated in accordance with the data of the k-space in which the direction of the unmeasured region is the down direction, the reconstruction image illustrated in (A1) of FIG. 13 cannot be used as the input image of the 40% CNN as it is. The reason is that, as illustrated in (B2) of FIG. 13, the 40% CNN of the present example is generated in accordance with the data of the k-space in which the direction of the unmeasured region is the down direction, whereas the data of the k-space corresponding to the reconstruction image illustrated in (A1) of FIG. 13 is the data of the k-space in which the direction of the unmeasured region is the up direction as illustrated in (B1) of FIG. 13, and the directions of two unmeasured regions are different from each other.

Therefore, the image calculation unit 230 of the processor 202 generates the inverted image illustrated in (A2) of FIG. 13 by performing top-bottom inversion on the reconstruction image of (A1) of FIG. 13. Since the data of the k-space corresponding to the inverted image is the data of the k-space in which the direction of the unmeasured region is the down direction as illustrated in (B2) of FIG. 13, the 40% CNN can be applied. That is, the CNN estimation unit 236 sets the inverted image illustrated in (A2) of FIG. 13 as the input image of the 40% CNN and acquires the corrected image estimated by the CNN as the intermediate image from the 40% CNN ((A3) of FIG. 13).

Subsequently, the image calculation unit 230 of the processor 202 obtains the final image by performing top-bottom inversion on the corrected image output from the 40% CNN again ((A4) of FIG. 13). The final image illustrated in (A4) of FIG. 13 is oriented in the same direction as the first reconstruction image illustrated in (A1) of FIG. 13.

In the example illustrated in FIG. 13, the 40% CNN generated for the data of the k-space in which the direction of the unmeasured region is the specific direction by performing top-bottom inversion on the reconstruction image can be applied, but, for example, in a case in which the data of the k-space in which the unmeasured region is present at the end part in the right direction as illustrated in (A) of FIG. 4 is acquired, the reconstruction image generated by performing an inverse Fourier transform on the data of the k-space can be rotated by 90 degrees clockwise on FIG. 4, the image rotated by 90 degrees clockwise can be used as the input image of the 40% CNN, and the output image of the 40% CNN can be rotated by 90 degrees counterclockwise to be used as the final image.

Similarly, in a case in which the data of the k-space illustrated in (B) of FIG. 4 is acquired, the reconstruction image generated by performing an inverse Fourier transform on the data of the k-space can be rotated by 90 degrees counterclockwise on FIG. 4, the image rotated by 90 degrees counterclockwise can be used as the input image of the 40% CNN, and the output image of the 40% CNN can be rotated by 90 degrees clockwise to be used as the final image.

According to the fourth embodiment of the MRI apparatus 10, even in a case in which the direction of the unmeasured region of the k-space is any of the four directions as illustrated in (A) to (D) of FIG. 4, one 40% CNN can be applied to the CNN estimation for the data of each k-space.

A case has been described in which the proportion of the unmeasured region of the k-space is 40%, but, in a case other than 40%, the processing of making the proportion of the unmeasured region of the k-space 40% as described in the first to third embodiments can be performed, and then the processing of the fourth embodiment can be applied.

### Fifth Embodiment of MRI Apparatus

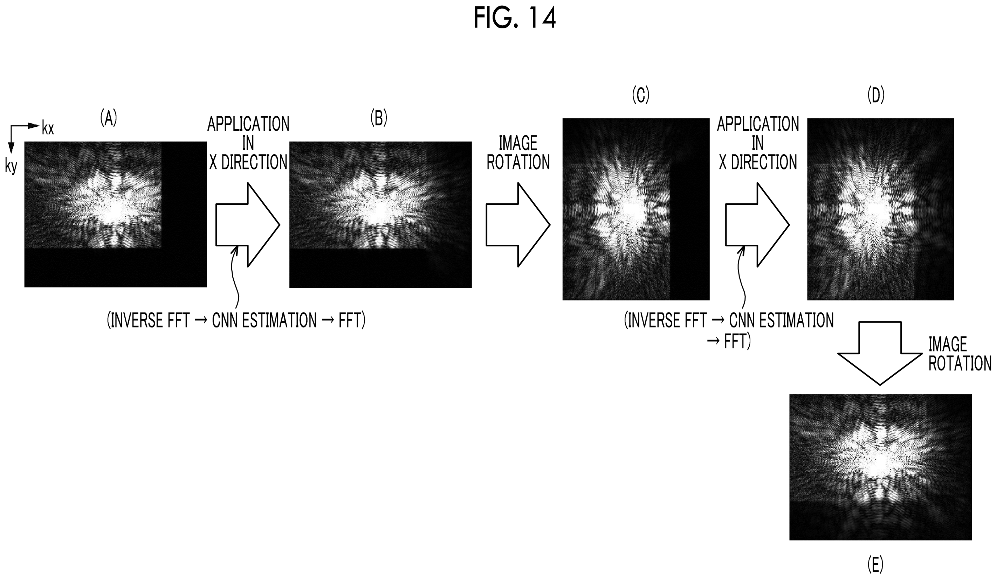

FIG. 14 is a diagram illustrating the fifth embodiment of the MRI apparatus according to the embodiment of the present invention, and is a diagram illustrating an embodiment in which the common CNN can be applied to the data of the k-space in which the asymmetrical unmeasured regions in the k-space are present in two directions.

The k-space (second k-space) illustrated in (A) of FIG. 14 includes two adjacent regions (first region and second region) among the regions at the end parts of the second k-space in the four directions as the unmeasured region (second unmeasured region).

The measurement unit 100 of the MRI apparatus 10 acquires the second partial measurement data of the second measurement region excluding the second unmeasured region of the second k-space by executing the half-scan measurement and the half-echo measurement.

The k-space data generation unit 232 of the processor 202 generates the data of the second k-space by arranging the second partial measurement data in the second measurement region of the second k-space and filling the asymmetrical second unmeasured region with the zero data ((A) of FIG. 14).

In a case of the second k-space illustrated in (A) of FIG. 14, the region at the end part in the right direction of the second k-space and the region at the end part in the down direction of the second k-space correspond to the first region and the second region of the second unmeasured region, respectively.

In the present example, in order to simplify the description, each of the proportion of the first region and the proportion of the second region of the second unmeasured region with respect to the entire region of the second k-space is 40%. In addition, the 40% CNN is trained using the training image in which the direction of the unmeasured region corresponds to the right direction.

The inverse Fourier transform unit 234 generates the first intermediate image by performing an inverse Fourier transform on the data of the second k-space ((A) of FIG. 14), and the CNN estimation unit 236 uses the 40% CNN, inputs the first intermediate image as the input image of the 40% CNN, and acquires the output image from the 40% CNN as the second intermediate image. The Fourier transform unit 238 generates the data of the k-space (third k-space) by performing a Fourier transform on the second intermediate image estimated by the CNN ((B) of FIG. 14).

Data (corrected data) in which the estimation result by the CNN estimation is reflected is added to the first region at the end part in the right direction of the data of the third k-space illustrated in (B) of FIG. 14. On the other hand, the second region at the end part in the down direction of the data of the third k-space illustrated in (B) of FIG. 14 is maintained as it is with the zero data filled. This is because the 40% CNN is trained using the training image in which the direction of the unmeasured region corresponds to the right direction.

Next, the image calculation unit 230 of the processor 202 generates the data of the fourth k-space by rotating the data of the third k-space illustrated in (B) of FIG. 14 by 90 degrees counterclockwise ((C) of FIG. 14). This is to move the second region at the end part in the down direction of the second unmeasured region of the third k-space illustrated in (B) of FIG. 14 to the end part in the right direction by rotation.

Subsequently, the inverse Fourier transform, the CNN estimation, and the Fourier transform are executed on the data of the fourth k-space after the rotation illustrated in (C) of FIG. 14 in the same manner as the processing on the data of the second k-space illustrated in (A) of FIG. 14. That is, the inverse Fourier transform unit 234 generates the fourth reconstruction image by performing an inverse Fourier transform on the data of the fourth k-space illustrated in (C) of FIG. 14, and the CNN estimation unit 236 inputs the fourth reconstruction image as the input image of the 40% CNN and acquires the output image in which the CNN estimation result is reflected from the 40% CNN.

The Fourier transform unit 238 can acquire the data of the k-space illustrated in (D) of FIG. 14 by performing a Fourier transform on the output image from the 40% CNN, and can acquire the data of the k-space illustrated in (E) of FIG. 14 by rotating the data of the k-space illustrated in (D) of FIG. 14 by 90 degrees in a direction opposite to the direction of the rotation in a case of generating the third reconstruction image (that is, the clockwise direction).

In the present example, the data of the third k-space illustrated in (B) of FIG. 14 is rotated by 90 degrees counterclockwise, but the present invention is not limited to this, and the second intermediate image may be rotated by 90 degrees counterclockwise to generate the data of the fourth k-space ((B) of FIG. 14) obtained by performing a Fourier transform on the rotated second intermediate image.

According to the fifth embodiment of the MRI apparatus 10, even in a case in which the second unmeasured region of the second k-space includes two adjacent regions (first region and second region) among the regions at the end parts of the second k-space in the four directions, the degradation of image quality due to the zero data filling the second unmeasured region can be reduced by applying a single 40% CNN.

That is, even in a case in which the second unmeasured region of the second k-space includes two adjacent regions among the regions at the end parts of the second k-space in the four directions, it is not necessary to prepare a dedicated CNN that reduces the degradation of image quality due to the zero data over the two regions, and the same processing as the dedicated CNN can be performed by combining a single CNN or two CNNs.

In the present example, since each of the proportion of the first region and the proportion of the second region of the second unmeasured region with respect to the entire region of the second k-space is 40%, a single 40% CNN can be applied, but, for example, in a case in which the proportion of the first region and the proportion of the second region of the second unmeasured region are 40% and 30%, respectively, according to the fifth embodiment of the MRI apparatus 10, the case can be handled by simply preparing two CNNs of 40% and 30%, and in a case in which the first to third embodiments are combined, the 40% CNN can be applied to the CNN estimation even in a case in which the proportion of the second region of the second unmeasured region is 30%.

### Sixth Embodiment of MRI Apparatus

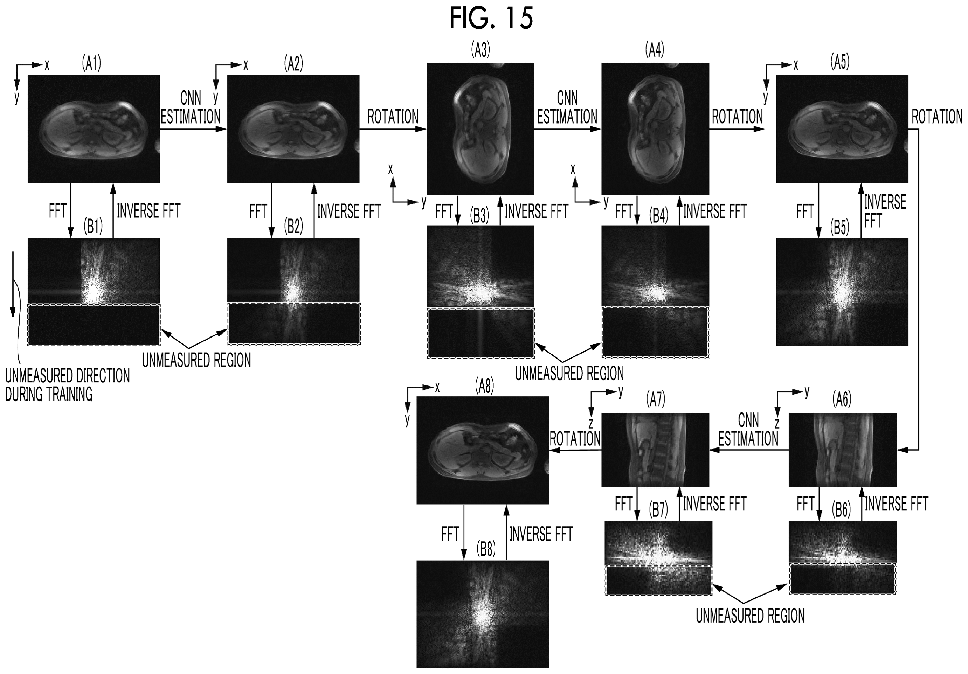

FIG. 15 is a diagram illustrating a sixth embodiment of the MRI apparatus according to the embodiment of the present invention, and is a diagram illustrating an embodiment in which the common CNN can be applied to the data of the k-space in which the asymmetrical unmeasured regions in the k-space are present in three directions in a three-dimensional space.

That is, the sixth embodiment illustrated in FIG. 15 is a modification example of the fifth embodiment illustrated in FIG. 14, and applies the CNN estimation to the data of the three-dimensional k-space.

(A1) to (A8) of FIG. 15 are diagrams illustrating the reconstruction images (MR images), and (B1) to (B8) of FIG. 15 are diagrams illustrating the k-space data obtained by performing a Fourier transform on the reconstruction images illustrated in (A1) to (A8) of FIG. 15, respectively. On the contrary, (A1) to (A8) of FIG. 15 are the reconstruction images obtained by performing an inverse Fourier transform on the data of the k-space illustrated in (B1) to (B8) of FIG. 15, respectively.

The imaging space in the measurement unit 100 of the MRI apparatus 10 can be defined by the orthogonal three axes of the X-axis, the Y-axis, and the Z-axis, but the reconstruction images illustrated in (A1) to (A5) and (A8) of FIG. 15 are images corresponding to the slice positions of a certain x-y plane of the subject 102, and the reconstruction images illustrated in (A6) and (A7) of FIG. 15 are images corresponding to the slice positions of a certain y-z plane of the subject 102.

In addition, the three-dimensional k-space illustrated in FIG. 15 includes the unmeasured regions at the end part in the negative kₓ direction, the end part in the positive k_{y} direction, and the end part in the positive k_{z} direction, and in the present example, the proportion of the unmeasured region with respect to the entire region in the two-dimensional k-space is 40%, and the 40% CNN is trained using a training image corresponding to the data of the k-space in which the end part in the positive k_{y} direction is the unmeasured region.

In a case in which the k-space data generation unit 232 of the processor 202 generates the data of the k-space (second k-space) illustrated in (B1) of FIG. 15, the inverse Fourier transform unit 234 generates the reconstruction image of (A1) of FIG. 15 by performing an inverse Fourier transform on the data of the second k-space of (B1) of FIG. 15.

The CNN estimation unit 236 uses the 40% CNN, inputs the reconstruction image of (A1) of FIG. 15 as the input image of the 40% CNN, and outputs the reconstruction image after the CNN estimation illustrated in (A2) of FIG. 15 from the 40% CNN.

Subsequently, the image calculation unit 230 of the processor 202 acquires the reconstruction image illustrated in (A3) of FIG. 15 by rotating the reconstruction image of (A2) of FIG. 15 by 90 degrees counterclockwise.

The CNN estimation unit 236 inputs the reconstruction image of (A3) of FIG. 15 as the input image of the 40% CNN, and outputs the reconstruction image after the CNN estimation illustrated in (A4) of FIG. 15 from the 40% CNN.

The image calculation unit 230 of the processor 202 rotates the reconstruction image of (A4) of FIG. 15 by 90 degrees clockwise, performs a Fourier transform on the image ((A5) of FIG. 15) rotated by 90 degrees clockwise, and acquires the data of the k-space ((B5) of FIG. 15). The data of the k-space ((B4) of FIG. 15) obtained by performing a Fourier transform on the reconstruction image of (A4) of FIG. 15 may be acquired, and the data of the k-space ((B5) of FIG. 15) may be acquired by rotating the data of the k-space by 90 degrees clockwise.

Next, the image calculation unit 230 acquires the data of the k-space having the k_{y} axis and the k_{z} axis by rotating the three-dimensional k-space about the kₓ axis of the k-space illustrated in (B5) of FIG. 15 and further rotating the three-dimensional k-space about the k_{Z} axis ((B6) of FIG. 15). The inverse Fourier transform unit 234 generates the reconstruction image of (A6) of FIG. 15 by performing an inverse Fourier transform on the data of the k-space illustrated in (B6) of FIG. 15. The reconstruction image illustrated in (A6) of FIG. 15 corresponds to an image obtained by rotating the reconstruction image illustrated in (A4) of FIG. 15 about the x-axis and the z-axis.

Subsequently, the CNN estimation unit 236 inputs the reconstruction image of (A6) of FIG. 15 as the input image of the 40% CNN, and outputs the reconstruction image ((A7) of FIG. 15) after the CNN estimation from the 40% CNN.

The Fourier transform unit 238 acquires the data of the k-space illustrated in (B7) of FIG. 15 by performing a Fourier transform on the reconstruction image illustrated in (A7) of FIG. 15. The image calculation unit 230 acquires the data of the k-space having the k_{y} axis and the k_{z} axis by rotating the three-dimensional k-space about the k_{y} axis of the k-space illustrated in (B7) of FIG. 15 and further rotating the three-dimensional k-space about the k_{z} axis ((B8) of FIG. 15). The inverse Fourier transform unit 234 generates the reconstruction image of (A8) of FIG. 15 by performing an inverse Fourier transform on the data of the k-space illustrated in (B8) of FIG. 15. The reconstruction image illustrated in (A8) of FIG. 15 corresponds to an image obtained by rotating the reconstruction image illustrated in (A7) of FIG. 15 about the x-axis and the z-axis.

According to the sixth embodiment of the MRI apparatus 10, the common CNN can be applied to the CNN estimation for the data of the k-space in which the asymmetrical unmeasured regions in the k-space are present in three directions in the three-dimensional space, and thus the number of CNNs to be prepared can be reduced.

### Seventh Embodiment of MRI Apparatus

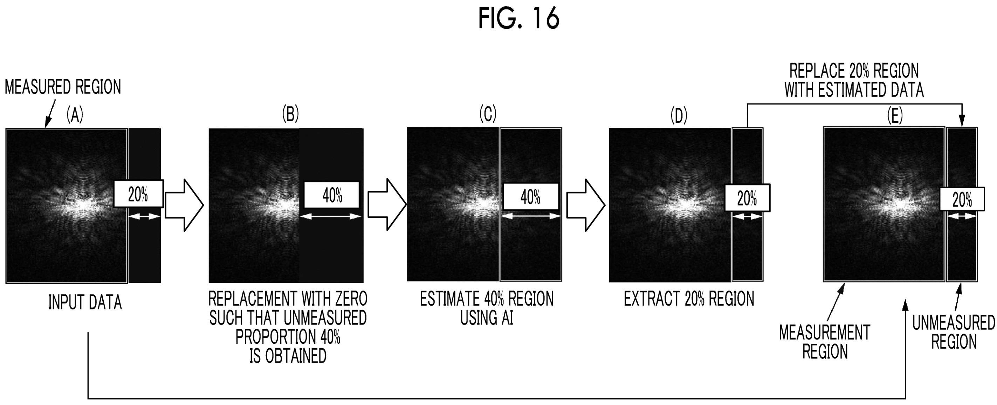

FIG. 16 is a diagram illustrating a seventh embodiment of the MRI apparatus according to the embodiment of the present invention, and is a diagram illustrating an embodiment in which the CNN can be applied to the data of the second k-space in which the second proportion of the asymmetrical second unmeasured region with respect to the entire region of the second k-space is less than the first proportion of the first unmeasured region with respect to the entire region of the first k-space corresponding to the training image used for training the CNN.

(A) of FIG. 16 is a diagram illustrating an example of the data of the second k-space generated by the k-space data generation unit 232. In the second k-space illustrated in (A) of FIG. 16, the asymmetrical second unmeasured region is present at the end part in the right direction, and the second proportion of the second unmeasured region with respect to the entire region of the second k-space is 20%. Therefore, the proportion of the measurement region (second measurement region) with respect to the entire region of the second k-space is 80%.

In addition, the memory 204 illustrated in FIG. 1 stores a trained 40% CNN corresponding to the first k-space in which the first proportion of the first unmeasured region with respect to the entire region of the first k-space is 40% and the direction of the first unmeasured region is present at the end part in the right direction.

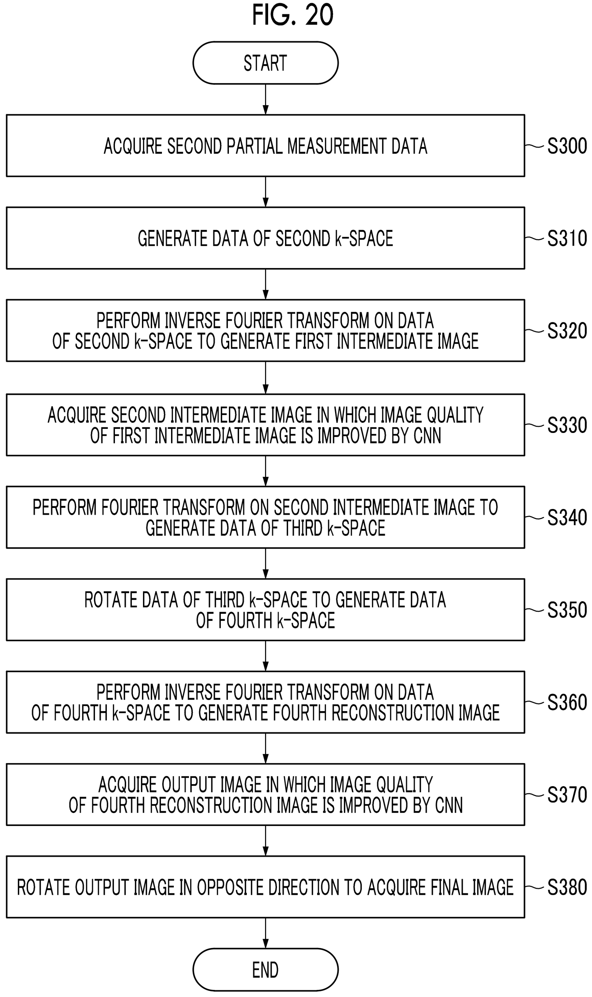

Since the second proportion (in the example illustrated in (A) of FIG. 16, 20%) of the second unmeasured region of the generated data of the second k-space is less than the first proportion (in the present example, 40%) of the first unmeasured region with respect to the entire region of the first k-space corresponding to the training image used for training the CNN, the k-space data generation unit 232 generates the data of the third k-space by replacing a partial region of the second partial measurement data of the second k-space with the zero data such that the second proportion (20%) becomes the first proportion (40%) ((B) of FIG. 16).

The inverse Fourier transform unit 234 generates the MR image (third reconstruction image) by performing an inverse Fourier transform on the data of the third k-space illustrated in (B) of FIG. 16. The CNN estimation unit 236 uses the 40% CNN, inputs the third reconstruction image as the input image of the 40% CNN, and outputs the output image from the 40% CNN as the intermediate image. The Fourier transform unit 238 generates the data of the k-space (fourth k-space) by performing a Fourier transform on the intermediate image estimated by the CNN ((C) of FIG. 16).

The region of 40% in the right direction of the fourth k-space illustrated in (C) of FIG. 16 includes the corrected data in which the CNN estimation is reflected.

The k-space data generation unit 232 extracts a region of 20% at the right end in the region of 40% in the right direction of the fourth k-space illustrated in (C) of FIG. 16 ((D) of FIG. 16), and combines the data of the extracted region of 20% and the second partial measurement data of the second measurement region of 80% of the second k-space illustrated in (A) of FIG. 16 to generate the data of the fifth k-space illustrated in (E) of FIG. 16.

According to the seventh embodiment of the MRI apparatus 10, the corrected data in which the CNN estimation result by the 40% CNN is reflected is added to the region of 20% at the right end of the data of the fifth k-space illustrated in (E) of FIG. 16, and the degradation of image quality of the reconstruction image generated by using the data of the fifth k-space can be reduced.

### First Embodiment of Operation Method of MRI Apparatus

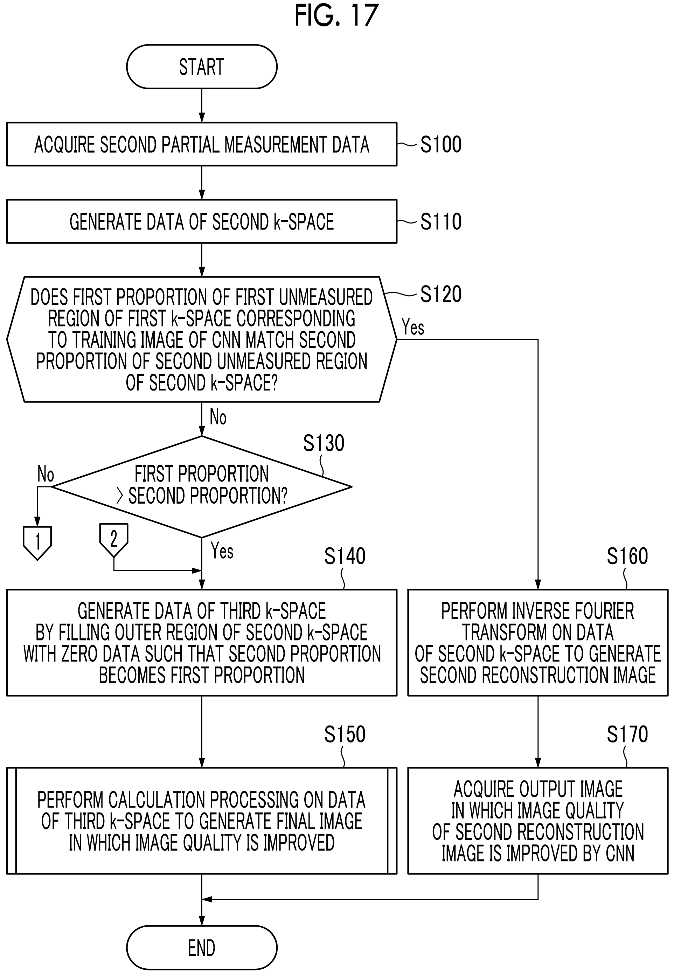

FIG. 17 is a flowchart illustrating a first embodiment of the operation method of the MRI apparatus according to the embodiment of the present invention.

The processing of each step of the operation method of the MRI apparatus illustrated in FIG. 17 corresponds to the processing performed by the processor 202 of the control device 200 illustrated in FIG. 1.

In FIG. 17, the processor 202 acquires the second partial measurement data of the asymmetric second measurement region of the k-space (second k-space) from the measurement unit 100 of the MRI apparatus 10 (step S100).

The processor 202 generates the data of the second k-space by arranging the acquired second partial measurement data in the second measurement region of the second k-space and filling the unmeasured region (second unmeasured region) of the second k-space with the zero data (step S110).

The processor 202 determines whether or not the first proportion of the first unmeasured region with respect to the entire region of the first k-space corresponding to the training image of the CNN used for the CNN estimation and the second proportion of the second unmeasured region of the second k-space match each other (step S120).

In a case in which it is determined that the first proportion and the second proportion do not match, the processor 202 further determines whether or not the first proportion is greater than the second proportion (step S130).

In a case in which it is determined that the first proportion is greater than the second proportion (in a case of "Yes"), the processing proceeds to step S140, where the processor 202 generates the data of the third k-space by filling the outer region of the second k-space with the zero data such that the second proportion of the second k-space generated in step S110 becomes the first proportion (see (B) of FIG. 10 and (A2) of FIG. 11).

Subsequently, the processor 202 performs calculation processing on the data of the third k-space to generate the final image in which the image quality is improved (the degradation of image quality is reduced) (step S150). Details of the processing in step S150 will be described later.

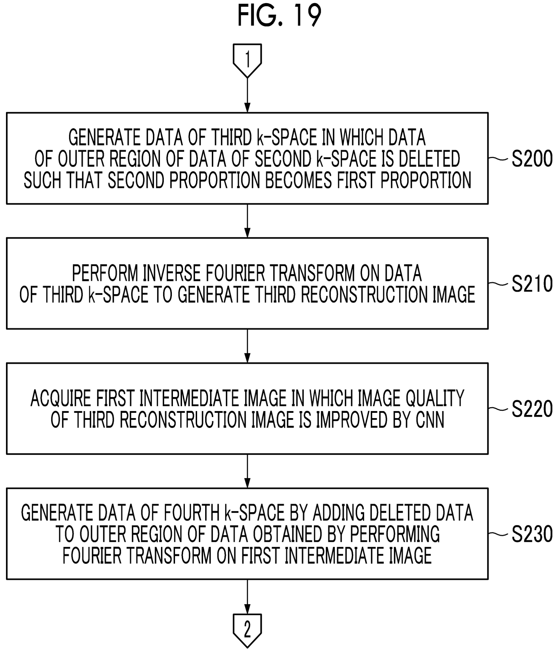

On the other hand, in a case in which it is determined that the first proportion is less than the second proportion in step S130 (in a case of "No"), the processing proceeds to the processing illustrated in FIG. 19.

In addition, in a case in which it is determined that the first proportion and the second proportion match each other in step S120 (in a case of "Yes"), the processing proceeds to step S160.

In step S160, the data of the second k-space generated in step S110 is subjected to an inverse Fourier transform to generate the MR image (second reconstruction image).

Then, the processor 202 uses the CNN used for the CNN estimation as the determination target in step S120, inputs the second reconstruction image as the input image of the CNN, and acquires the output image (final image) from the CNN (step S170). Since the CNN estimation is performed even in a case in which the second unmeasured region is included in the second k-space, the final image is an image in which the degradation of image quality is improved.

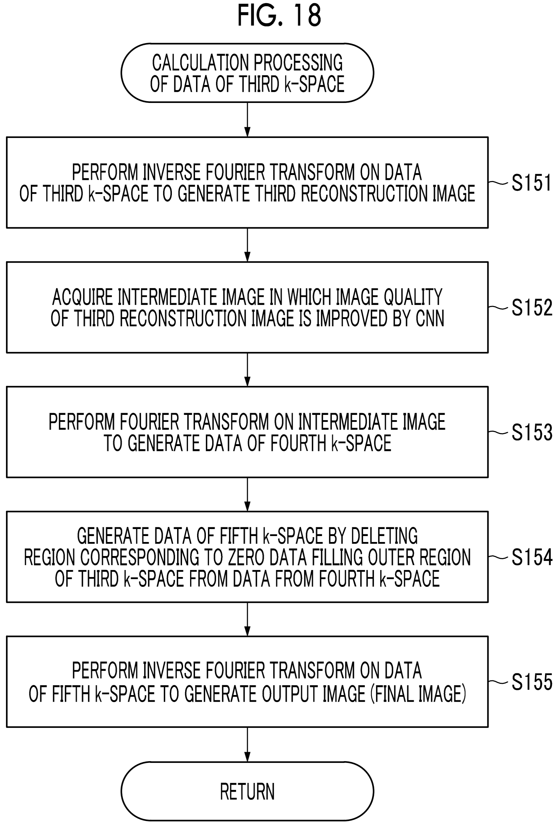

FIG. 18 is a subroutine illustrating the processing of step S150 illustrated in FIG. 17.

In FIG. 18, the processor 202 generates the third reconstruction image by performing an inverse Fourier transform on the data of the third k-space generated in step S140 (step S151). The processor 202 inputs the third reconstruction image as the input image of the CNN, acquires the output image (intermediate image) in which the degradation of image quality of the third reconstruction image is improved by the CNN (step S152), and generates the data of the fourth k-space by performing a Fourier transform on the intermediate image (step S153).

Subsequently, the processor 202 generates the data of the fifth k-space by deleting a region corresponding to the zero data filling the outer region of the third k-space from the data of the fourth k-space (step S154), and generates the output image (final image) by performing an inverse Fourier transform on the data of the fifth k-space (step S155).

FIG. 19 is a flowchart illustrating a part of the processing in a case in which it is determined that the first proportion is less than the second proportion (in a case of "No") in step S130 illustrated in FIG. 17.

In FIG. 19, in a case in which it is determined that the first proportion is less than the second proportion, the data of the outer region of the second k-space is deleted such that the second proportion becomes the first proportion, and the data of the third k-space after the data deletion is generated (step S200, see (B) of FIG. 12).

Then, the processor 202 generates the third reconstruction image by performing an inverse Fourier transform on the generated data of the third k-space (step S210), inputs the third reconstruction image as the input image of the CNN, and acquires the output image from the CNN as the first intermediate image (step S220). Since the CNN estimation is performed even in a case in which the unmeasured region is included in the third k-space, the first intermediate image is an image in which the degradation of image quality is improved.

Next, the processor 202 generates the data of the fourth k-space by adding the data deleted in step S200 to the outer region of the data obtained by performing a Fourier transform on the first intermediate image (see (C) of FIG. 12) (step S230, see (D) of FIG. 12).

The data of the fourth k-space is data in which the data (corrected data) in which the estimation result by the CNN estimation is reflected is added to a part of the unmeasured region of the second k-space. In addition, since the fourth k-space includes the data of the region deleted in step S200 (particularly, the data of a part of the unmeasured region and the data of the unmeasured region that is smaller than the first proportion), the processor 202 returns to step S140 illustrated in FIG. 17 to perform the CNN estimation again, and performs the processing of step S140 and step S150.

According to the first embodiment of the operation method of the MRI apparatus, even in a case in which the second proportion of the second unmeasured region with respect to the entire region of the second k-space is less than or greater than the first proportion of the first unmeasured region with respect to the entire region of the first k-space, the common CNN trained to correspond to the data of the first k-space can be applied to the CNN estimation, and thus the number of CNNs to be prepared can be reduced.

### Second Embodiment of Operation Method of MRI Apparatus

FIG. 20 is a flowchart illustrating a second embodiment of the operation method of the MRI apparatus according to the embodiment of the present invention, and illustrates a processing procedure corresponding to the fourth embodiment of the MRI apparatus 10 illustrated in FIG. 14.

In FIG. 20, the processor 202 acquires the second partial measurement data of the asymmetric second measurement region of the second k-space from the measurement unit 100 of the MRI apparatus 10 (step S300). In this case, the second partial measurement data is the partial measurement data measured by using both the half-scan measurement and the half-echo measurement.

The processor 202 generates the data of the second k-space by arranging the second partial measurement data in the second measurement region of the second k-space and filling the asymmetrical second unmeasured region with the zero data (step S310, see (A) of FIG. 14).

The asymmetrical second unmeasured region includes the first regions and second regions that are two adjacent regions among the regions at the end parts of the second k-space in the four directions, and in the present example, the first region is a region at the end part in the right direction of the second k-space, and the second region is a region at the end part in the down direction of the second k-space. In addition, each of the second proportion of the first region and the second proportion of the second region of the second k-space with respect to the entire region of the second k-space is 40%.

The processor 202 generates the first intermediate image by performing an inverse Fourier transform on the data of the second k-space (step S320), inputs the first intermediate image as the input image of the CNN, and acquires the output image from the CNN as the second intermediate image (step S330). The CNN is a 40% CNN trained using the training image corresponding to the data of the first k-space in which the proportion of the first unmeasured region with respect to the entire region is 40%, and the first unmeasured region is a region at the end part of the first k-space in the right direction.

Then, the processor 202 generates the data of the third k-space by performing a Fourier transform on the second intermediate image (step S340). The data of the third k-space is data in which the zero data of the first region of the second k-space is corrected by the CNN estimation (see (B) of FIG. 14).

The processor 202 generates the data of the fourth k-space by rotating the third k-space (step S350). In the present example, the third k-space is rotated by 90 degrees counterclockwise such that the second region is located at the end part of the fourth k-space in the right direction.

Then, the processor 202 generates the fourth reconstruction image by performing an inverse Fourier transform on the data of the fourth k-space (step S360), inputs the fourth reconstruction image as the input image of the 40% CNN, and acquires the output image from the 40% CNN (step S370).

Finally, the processor 202 acquires the final image by rotating the output image of the 40% CNN in the opposite direction (step S380). In the present example, since the rotation by 90 degrees in the counterclockwise direction is performed in step S350, the output image is rotated by 90 degrees clockwise in step S380.

According to the second embodiment of the operation method of the MRI apparatus, even in a case in which two adjacent regions (first region and second region) among the regions at the end parts in the four directions of the second k-space are the unmeasured regions, the common CNN can be applied to the CNN estimation, and thus the number of CNNs to be prepared can be reduced.

In the second embodiment, the data of the third k-space is rotated, but the present invention is not limited to this, and the second intermediate image acquired in step S330 may be rotated to generate the data of the fourth k-space by performing a Fourier transform on the rotated second intermediate image.

### Third Embodiment of Operation Method of MRI Apparatus

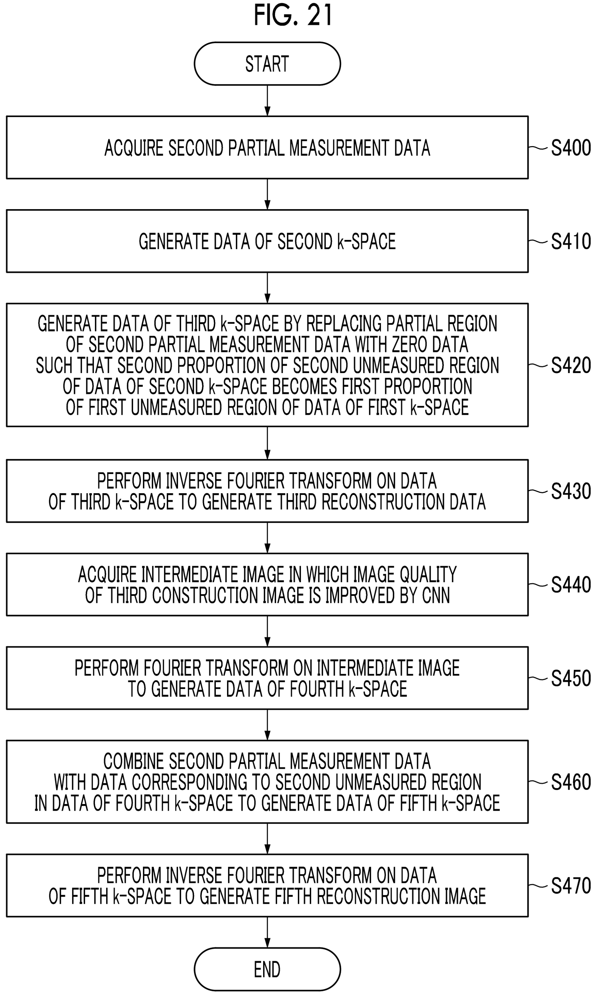

FIG. 21 is a flowchart illustrating a third embodiment of the operation method of the MRI apparatus according to the embodiment of the present invention, and illustrates a processing procedure corresponding to the seventh embodiment of the MRI apparatus 10 illustrated in FIG. 16.

In FIG. 21, the processor 202 acquires the second partial measurement data of the asymmetric second measurement region of the second k-space from the measurement unit 100 of the MRI apparatus 10 (step S400). In this case, the second k-space has the asymmetrical second unmeasured region at the end part in the right direction, and the second proportion of the second unmeasured region with respect to the entire region of the second k-space is 20%. Therefore, the proportion of the second measurement region with respect to the entire region of the second k-space is 80%.

The processor 202 generates the data of the second k-space by arranging the second partial measurement data in the second measurement region of the second k-space and filling the asymmetrical second unmeasured region with the zero data (step S410, see (A) of FIG. 16).

Subsequently, the processor 202 generates the data of the third k-space by replacing a part of the second partial measurement data with the zero data such that the second proportion of the second unmeasured region with respect to the entire region of the second k-space becomes the first proportion of the first unmeasured region with respect to the entire region (step S420). In the present example, the CNN applied to the CNN estimation is a 40% CNN trained using the data of the first k-space in which the proportion of the first unmeasured region with respect to the entire region is 40%, and the first unmeasured region is a region at the end part of the first k-space in the right direction. Therefore, in step S420, a part of the second partial measurement data is replaced with the zero data, the second unmeasured region of 20% of the second k-space is set to 40%, and the data is used as the data of the third k-space (see (B) of FIG. 16).

The processor 202 generates the third reconstruction image by performing an inverse Fourier transform on the data of the third k-space (step S430), inputs the third reconstruction image as the input image of the 40% CNN, and acquires the output image from the 40% CNN as the intermediate image (step S440).

Subsequently, the processor 202 generates the data of the fourth k-space by performing a Fourier transform on the intermediate image acquired in step S440 (step S450, see (C) of FIG. 16).

The processor 202 generates the data of the fifth k-space by combining the second partial measurement data of 80% of the second k-space and the 20% data corresponding to the second unmeasured region of the second k-space in the data of the fourth k-space (step S460, see (E) of FIG. 16). Here, the region of 20% of the fifth k-space corresponding to the second unmeasured region of the second k-space includes the corrected data in which the CNN estimation result by the 40% CNN is reflected.

The processor 202 generates the fifth reconstruction image by performing an inverse Fourier transform on the data of the fifth k-space (step S470).

According to the third embodiment of the operation method of the MRI apparatus, the data of the fifth k-space in which the zero data filling the second unmeasured region of the second k-space is replaced with the corrected data in which the estimation result by the CNN is reflected can be generated. The fifth reconstruction image acquired by performing an inverse Fourier transform on the data of the fifth k-space is an image in which the image quality is improved as compared with the reconstruction image acquired by performing an inverse Fourier transform on the data of the second k-space.

### Others

In the present embodiment, the trained model such as the CNN stored in the memory 204 is generated using the training image corresponding to the data of the first k-space in which the first proportion of the first unmeasured region with respect to the entire region of the first k-space is 40%, but the present invention is not limited to this, and for example, five trained models with unmeasured percentages of 40%, 35%, 30%, 25%, and 20% in 5% increments or three trained models with unmeasured percentages of 40%, 30%, and 20% in 10% increments may be prepared, and a plurality of trained models may be stored in the memory 204.

In a case in which five trained models in increments of 5% are prepared and the second proportion of the second unmeasured region of the generated second k-space is, for example, between the first proportions of 35% and 30%, any one of the trained models of 35% or 30% is used. That is, in a case of the embodiment of the invention in which the trained model in which the second proportion is less than the first proportion is used, it is preferable to use the trained model in which the first proportion corresponds to 35%, and in a case of the embodiment of the invention in which the trained model in which the second proportion is greater than the first proportion is used, it is preferable to use the trained model in which the first proportion corresponds to 30%.

Furthermore, the present invention may be configured by combining the plurality of above-described embodiments as appropriate.

In the present embodiment, for example, each processing of the processor such as the measurement controller, the image calculation unit, the display controller, and the recording controller is executed by any computer. Further, any computer may execute these processes by a processor as hardware, a program as software, or a combination thereof. In such a case, the processor is configured to execute various types of processing in the present embodiment in cooperation with the program, and can function as each unit or each means in the present embodiment. The execution order of the processing by the processor is not limited to the above-described order and may be changed as appropriate. Any computer may be a general-purpose computer, a computer for specific use, a workstation, or another system that can execute each processing.

The processor may be configured by one or a plurality of pieces of hardware, and the type of hardware is not limited. The processor may be configured by, for example, a central processing unit (CPU), a micro processing unit (MPU), a programmable logic device such as a field programmable gate array (FPGA), a dedicated circuit for executing specific processing, such as an application specific integrated circuit (ASIC), or hardware such as a graphics processing unit (GPU) or a neural processing unit (NPU). Furthermore, the type of hardware may be a combination of different types of hardware components. In a case in which the plurality of hardware components are configured to execute one or a plurality of types of processing of a certain processor, the plurality of hardware components may be present in devices physically separated from each other or may be present in the same device. Further, in any embodiment, the order of each processing performed by the processor is not limited to the above-described order, and may be changed as appropriate. The hardware is configured by an electric circuit (circuitry) in which circuit elements, such as semiconductor elements, are combined.

Further, the program may be software such as firmware or microcode. Additionally, the program may be, for example, a program module group, and each function thereof may be executed by the processor configured to execute the corresponding function. The program may be a program code or a plurality of code segments stored in one or more non-transitory computer-readable media (for example, a storage medium and other storages). The program may be distributed and stored across a plurality of non-transitory computer-readable media existing in devices physically separated from each other. The program code or the code segment may represent any combination of procedures, functions, subprograms, routines, subroutines, modules, software packages, classes, or commands, data structures, or program statements. The program code or the code segment may be connected to another code segment or a hardware circuit by transmitting and receiving information, data, an argument, a parameter, or a content of a memory.

Further, the present invention is not limited to the above-described embodiments, and it goes without saying that the modifications can be made without departing from the scope of the present invention as defined by the claims.

### Explanation of References

10: MRI apparatus
100: measurement unit
102: subject
103: bed
104: static field magnet
106: gradient coil
108: transmit coil
110: receive coil
112: radio frequency magnetic field generator
114: gradient magnetic field power supply
116: receiver
118: sequencer
200: control device
202: processor
204: memory
206: input/output interface
208: display
210: operation unit
220: measurement controller
230: image calculation unit
232: k-space data generation unit
234: inverse Fourier transform unit
236: CNN estimation unit
238: Fourier transform unit
240: display controller
250: recording controller
S100 to S170: step of flowchart illustrating first embodiment of operation method of MRI apparatus
S151 to S155: step of subroutine illustrating processing of step S150
S200 to S230: step illustrating part of processing in case in which it is determined in step S130 that first proportion is less than second proportion
S300 to S380: step of flowchart illustrating second embodiment of operation method of MRI apparatus
S400 to S470: step of flowchart illustrating third embodiment of operation method of MRI apparatus

## Claims

1. A magnetic resonance imaging apparatus (10) comprising:
a processor (202); and
a memory (204) that stores a trained model,
wherein the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, and
the processor (202) is configured to:
acquire second partial measurement data of a second measurement region excluding a second unmeasured region that is asymmetrical and arbitrarily set for a second k-space;
fill the second unmeasured region with zero data and generate data of the second k-space consisting of the second partial measurement data and the zero data filling the second unmeasured region; and
in a case in which a first proportion of the first unmeasured region with respect to an entire region of the first k-space and a second proportion of the second unmeasured region with respect to an entire region of the second k-space are different from each other, generate data of a third k-space in which an outer region of the second k-space is filled with zero data such that the second proportion becomes the first proportion.

2. The magnetic resonance imaging apparatus (10) according to claim 1,
wherein the trained model is configured by a neural network.

3. The magnetic resonance imaging apparatus (10) according to claim 1 or 2,
wherein the second proportion is less than the first proportion.

4. The magnetic resonance imaging apparatus (10) according to any one of claims 1 to 3,
wherein the processor (202) is configured to:
perform an inverse Fourier transform on the data of the third k-space to generate a third reconstruction image;
input the third reconstruction image as an input image to the trained model and acquire an output image from the trained model as an intermediate image;
perform a Fourier transform on the intermediate image to generate data of a fourth k-space;
delete a region corresponding to a region filled with zero data on an outer region of the third k-space from the data of the fourth k-space to generate data of a fifth k-space; and
perform an inverse Fourier transform on the data of the fifth k-space to generate an output image.

5. The magnetic resonance imaging apparatus (10) according to any one of claims 1 to 4,
wherein the processor (202) is configured to:
in a case in which the first proportion and the second proportion match each other, perform an inverse Fourier transform on the data of the second k-space to generate the second reconstruction image; and
input the second reconstruction image as an input image to the trained model and acquire an output image from the trained model.

6. The magnetic resonance imaging apparatus (10) according to any one of claims 1 to 5,
wherein the memory (204) stores, as the trained model, a plurality of trained models having different first proportions, and
the processor (202) is configured to:
in a case in which the first proportion and the second proportion are different from each other, select a trained model for which the first proportion closest to the second proportion is set from among the plurality of trained models; and
generate the data of the third k-space by filling the outer region of the second k-space with the zero data such that the second proportion becomes the first proportion set for the selected trained model.

7. The magnetic resonance imaging apparatus (10) according to any one of claims 1 to 6,
wherein the memory (204) stores a plurality of trained models corresponding to four directions of the first k-space and directions formed by combining the four directions, in relation to a direction of the first unmeasured region of the first k-space, and
the processor (202) is configured to select a trained model corresponding to the same direction as a direction of the second unmeasured region of the second k-space from among the plurality of trained models.

8. The magnetic resonance imaging apparatus (10) according to any one of claims 1 to 7,
wherein the first unmeasured region that is asymmetrical and set in advance for the first k-space is a region of an end part of the first k-space in any specific direction among four directions, and
the processor (202) is configured to:
in a case in which a direction of the second unmeasured region of the second k-space is different from the specific direction, rotate or invert the data of the third k-space such that a direction of an unmeasured region of the data of the third k-space matches the specific direction, and generate a third reconstruction image by performing an inverse Fourier transform on the rotated or inverted data of the third k-space or by rotating or inverting an image generated by performing an inverse Fourier transform on the data of the third k-space; and
input the third reconstruction image as an input image to the trained model and acquire an output image from the trained model.

9. The magnetic resonance imaging apparatus (10) according to claim 8,
wherein the processor is configured to rotate or invert the output image in a direction opposite to a direction of the rotation in a case of generating the third reconstruction image.

10. An operation method of a magnetic resonance imaging apparatus (10) including a processor (202), and a memory (204) that stores a trained model, wherein the trained model is a model that has been trained through machine learning using a pair of ground-truth data and a training image, the ground-truth data being a first reconstruction image reconstructed from full measurement data in a first k-space, the training image being a second reconstruction image reconstructed from data that is generated from the full measurement data in the first k-space and that consists of zero data filling a first unmeasured region that is asymmetrical and set in advance for the first k-space and first partial measurement data of a first measurement region excluding the first unmeasured region in the full measurement data, the operation method comprising:
a step of acquiring (S100), by the processor (202), second partial measurement data of a second measurement region excluding a second unmeasured region that is asymmetrical and arbitrarily set for a second k-space;
a step of filling, by the processor (202), the second unmeasured region with zero data and generating data of the second k-space consisting of the second partial measurement data and the zero data filling the second unmeasured region; and
a step of generating (S140), by the processor (202), data of a third k-space by filling an outer region of the second k-space with zero data such that the second proportion becomes the first proportion, in a case in which a first proportion of the first unmeasured region with respect to an entire region of the first k-space and a second proportion of the second unmeasured region with respect to an entire region of the second k-space are different from each other.

11. The operation method of a magnetic resonance imaging apparatus (10) according to claim 10,
wherein the trained model is configured by a neural network.

12. The operation method of a magnetic resonance imaging apparatus (10) according to claim 10 or 11,
wherein the second proportion is less than the first proportion.

13. The operation method of a magnetic resonance imaging apparatus (10) according to any one of claims 10 to 12, the operation method comprising:
a step of performing, by the processor (202), an inverse Fourier transform on the data of the third k-space to generate a third reconstruction image;
a step of inputting, by the processor (202), the third reconstruction image as an input image to the trained model and acquiring an output image from the trained model as an intermediate image;
a step of performing, by the processor (202), a Fourier transform on the intermediate image to generate data of a fourth k-space;
a step of deleting, by the processor (202), a region corresponding to a region filled with zero data on an outer region of the third k-space from the data of the fourth k-space to generate data of a fifth k-space; and
a step of performing, by the processor (202), an inverse Fourier transform on the data of the fifth k-space to generate an output image.

14. The operation method of a magnetic resonance imaging apparatus (10) according to any one of claims 10 to 13, the operation method comprising:
a step of performing, by the processor (202), an inverse Fourier transform on the data of the second k-space to generate the second reconstruction image, in a case in which the first proportion and the second proportion match each other; and
a step of inputting, by the processor (202), the second reconstruction image as an input image to the trained model and acquiring an output image from the trained model.

15. A non-transitory computer-readable recording medium on which a program for causing a computer to execute the operation method of a magnetic resonance imaging apparatus (10) according to any one of claims 10 to 14 is recorded.
